# EUROPEAN PATENT SPECIFICATION

(11) **EP 3 301 584 B1**
(45) Date of publication and mention of the grant of the patent: **01.12.2021**
(21) Application number: 16817022.3
(22) Date of filing: 04.05.2016
(51) Int. Cl.: G06F 12/02

(54) **STORAGE SYSTEM, STORAGE MANAGEMENT DEVICE, STORAGE DEVICE, HYBRID STORAGE DEVICE, AND STORAGE MANAGEMENT METHOD**
SPEICHERSYSTEM, SPEICHERVERWALTUNGSVORRICHTUNG, SPEICHERVORRICHTUNG, HYBRIDSPEICHERVORRICHTUNG UND SPEICHERVERWALTUNGSVERFAHREN
SYSTÈME DE STOCKAGE, DISPOSITIF DE GESTION DE STOCKAGE, DISPOSITIF DE STOCKAGE, DISPOSITIF DE STOCKAGE HYBRIDE ET PROCÉDÉ DE GESTION DE STOCKAGE

(30) Priority: 29.06.2015 CN 201510369203
(43) Date of publication of application: 04.04.2018
(73) Proprietor: Huawei Technologies Co., Ltd., Longgang District Shenzhen, Guangdong 518129 (CN)
(72) Inventor: ZHANG, Zigang, Beijing 100190 (CN); XIONG, Jin, Beijing 100190 (CN); JIANG, Dejun, Beijing 100190 (CN)
(74) Representative: Körber, Martin Hans
(86) International application number: PCT/CN2016/081000
(87) International publication number: WO 2017/000658

(56) References cited:
- CN-A- 102 298 555
- CN-A- 103 049 389
- CN-A- 103 455 283
- CN-A- 104 298 681
- US-A1- 2009 193 182
- US-A1- 2011 225 347
- US-A1- 2011 264 843
- US-A1- 2012 023 144

## Description

### TECHNICAL FIELD

The present invention relates to the field of storage technologies, and in particular, to a storage system, a storage management apparatus, a storage, a hybrid storage apparatus, and a storage management method.

### BACKGROUND

A solid state disk (solid state disk, SSD) has such advantages as high performance, a low delay, low power consumption, and strong environment adaptability, and its costs are increasingly reduced. Therefore, the solid state disk is currently in increasingly common use, and mainly used as a cache of a hard disk drive (hard disk drive, HDD).

Unlike the HDD, the SSD does not allow overwriting at an original location, but requires erasure of original data before new data is written. In addition, the SSD is read and written in pages, but erasure is in physical blocks. Therefore, to update data in the SSD, updated data needs to be written to an idle location, and the original data is invalidated. When the SSD is full, a physical block that has a relatively large quantity of invalid data is erased.

A physical block to be erased from the SSD may include a large quantity of valid pages, and therefore data in these valid pages needs to be copied to an idle location before data in the physical block that needs to be erased is erased. This process is garbage collection. In the process of garbage collection, copying the data in these valid pages to an idle location adds extra data writing, that is, causes write amplification of the SSD. The write amplification of the SSD reduces performance of the SSD, and shortens a life of the SSD.

US 2011264843 A1 discloses an SSD, which includes at least two data storage areas. The SSD categorizes data based on a characteristic of the data, and stores the data in one of the at least two data storage areas based on the categorization.

CN 102298555 A discloses a NAND device which can categorize the data into hot data and cold data, and which stores the hot data and the cold data into different storage areas.

### SUMMARY

The present invention is defined by a storage system according to independent claim 1 and a storage management method according to independent claim 16. Additional features of the invention are provided in the dependent claims.

In the present invention, to-be-written data pages are classified so that each physical block in an SSD stores data pages of a same data category. Because the data pages of a same data category are updated at a basically consistent pace, quantities of valid data pages are in normal distribution in the physical blocks in accordance with the data categories of data pages in the physical blocks. For example, a physical block in which hot data that is frequently accessed is located has a relatively large quantity of invalid data pages, and a physical block in which cold data that is infrequently accessed is located has a relatively small quantity of invalid data pages. Such distribution of validity of data pages is different from that in the case of random writing in the prior art. A quantity of valid data pages in a to-be-erased physical block selected by the SSD according to a quantity of invalid data pages during garbage collection is necessarily less than a quantity of valid data pages in a to-be-erased physical block selected in the prior art. Therefore, in the method provided by the present invention, write amplification resulting when a physical block is erased is reduced.

### BRIEF DESCRIPTION OF DRAWINGS

To describe the technical solutions of the present invention more clearly, the following briefly describes the accompanying drawings showing embodiments of the present invention or the prior art. Apparently, the accompanying drawings in the following description show merely some embodiments of the present invention.
FIG. 1 is an architecture diagram of a system in which an SSD is used as a cache of an HDD in the prior art;
FIG. 2 is a schematic diagram of a change of a data address during data updating of an SSD in the prior art;
FIG. 3 is an architecture diagram of a first storage system 30 according to an embodiment of the present invention;
FIG. 4 is a schematic diagram of a correspondence between data categories, logical blocks, and physical blocks according to an embodiment shown in FIG. 3;
FIG. 5 is a schematic diagram of a process of writing a to-be-written data page in a data write request to an SSD according to an embodiment shown in FIG. 3;
FIG. 6 is a schematic diagram of a change of a logical block address in a logical block during updating of stored data according to the embodiment shown in FIG. 3;
FIG. 7 is a schematic diagram of migrating data in a to-be-erased physical block before erasing the physical block according to the embodiment shown in FIG. 3;
FIG. 8 is an architecture diagram of a second storage system according to an embodiment of the present invention;
FIG. 9 is a block diagram of a first storage management apparatus according to an embodiment of the present invention;
FIG. 10 is a block diagram of a second storage management apparatus according to an embodiment of the present invention;
FIG. 11 is a structural diagram of an SSD according to an embodiment of the present invention;
FIG. 12 is a structural diagram of a hybrid storage apparatus according to an embodiment of the present invention;
FIG. 13 is a flowchart of a method for writing data to an SSD by a manager according to an embodiment of the present invention;
FIG. 14 is a flowchart of a first specific implementation method for writing data to an SSD by a manager according to an embodiment of the present invention;
FIG. 15 is a flowchart of a second specific implementation method for writing data to an SSD by a manager according to an embodiment of the present invention;
FIG. 16 is a flowchart of a method for controlling, by a manager, an SSD to perform data erasure according to an embodiment of the present invention; and
**[0001]** FIG. 17 is a schematic diagram of a structural of a storage manager according to an embodiment of the present invention.

### DESCRIPTION OF EMBODIMENTS

The following clearly and completely describes the technical solutions of the present invention with reference to the accompanying drawings in the embodiments of the present invention. Apparently, the described embodiments are merely some but not all of the embodiments of the present invention.

A storage in the present invention includes multiple physical blocks, and new data can be written only when original data is erased. Data is written in pages, but erased in physical blocks. An SSD is a representative of such memories. The following embodiments are described by using an SSD as an example.

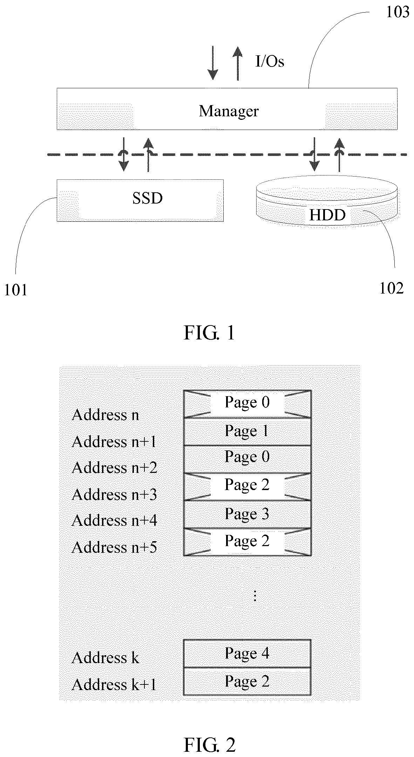

FIG. 1 is an architecture diagram of a system in which an SSD is used as a cache of an HDD in the prior art. Generally, frequently accessed data is stored in an SSD 101, and a manager 103 performs centralized management on the SSD 101 and an HDD 102. The manager 103 records, by using a mapping table, which data of the HDD 102 is cached in the SSD 101. When a request arrives, the manager 103 searches the mapping table to determine whether requested data is stored in the SSD 101. If the data is stored in the SSD 101, the data is read from the SSD 101; or if the data is not in the SSD 101, the data is read from the HDD 102. If the SSD 101 is fully written with data, data erasure is performed, so that infrequently used data is replaced.

For the architecture shown in FIG. 1, when the SSD 101 and the HDD 102 are used as a hybrid drive, the manager 103 may be a controller of the hybrid drive; when the SSD and the HDD are separately connected to a computer as independent devices, the manager 103 may be loaded in an operating system of the computer or may be loaded onto the computer as an independent module. The foregoing SSD 101 in FIG. 1 is used as a cache of the HDD, and in another application scenario, the SSD 101 may be used as an independent storage device. The present invention may be applied to the architecture shown in FIG. 1, or may be applied to another application scenario of the SSD 101.

The SSD is generally a NAND (not and, NAND) flash drive and may include multiple (for example, 1024) physical blocks, and each physical block includes multiple (for example, 64) physical pages. A physical page is a basic unit of data reading and data writing, and a physical block is a basic unit for the SSD to perform data erasure.

The SSD includes a flash translation layer (Flash translation layer, FTL), and the FTL may be used to record a correspondence between logical block addresses (Logical Block Address, LBA) of data and physical block addresses (Physical Block Address, PBA) in the SSD, and execute a data read operation or a data write operation according to the correspondence between logical block addresses and physical block addresses.

In addition, when data in the SSD needs to be updated, the FTL may further write, to an idle physical page of the SSD, "new data" resulting after updating, update the correspondence between LBAs of data and PBAs in the SSD, and mark a physical page that includes "old data" as an invalid page. As shown in FIG. 2, if a data updating request is to update data in page 0, the FTL writes updated data in page 0 to a physical page whose physical block address is n+2, and marks, as invalid, a physical page in which "old data" in page 0 is located and whose physical block address is n.

After the SSD is fully written, a physical block needs to be replaced, and the FTL selects a physical block that has a relatively large quantity of invalid pages to erase, so as to free space for storage of new data. However, because a physical block erased by the SSD may include a large quantity of valid data pages, data pages in these valid pages need to be migrated to another idle location before data in the physical block that needs to be erased is erased. This process is garbage collection. Because in the process of garbage collection, the data in the valid pages needs to be migrated to another idle location, migration of the valid pages brings about extra writing, and a quantity of times of data writing inside the SSD is increased, that is, write amplification is caused.

A technical solution provided by the present invention is intended to reduce write amplification resulting when a physical block is erased. The technical solution provided in the embodiments of the present invention is as follows: A manager classifies, into multiple data categories (for example, hot data, warm data, and cold data) according to an access status, data that needs to be written to an SSD, and then modifies the SSD, so that when storing data, the SSD stores data of a same data category in a same physical block. Because data pages of a same data category are updated at a basically consistent pace, quantities of valid data pages are in normal distribution in the physical blocks in accordance with the data categories of data pages in the physical blocks. For example, a physical block in which hot data that is frequently accessed is located has a relatively large quantity of invalid data pages, and a physical block in which cold data that is infrequently accessed is located has a relatively small quantity of invalid data pages. Such distribution of validity of data pages is different from that in the case of random writing in the prior art. A quantity of valid data pages in a to-be-erased physical block selected by the SSD according to a quantity of invalid data pages during garbage collection is necessarily less than a quantity of valid data pages in a to-be-erased physical block selected in the prior art. Therefore, in the method provided in the embodiments of the present invention, write amplification resulting when a physical block is erased is reduced.

The following describes the technical solution in detail by using different embodiments of the present invention.

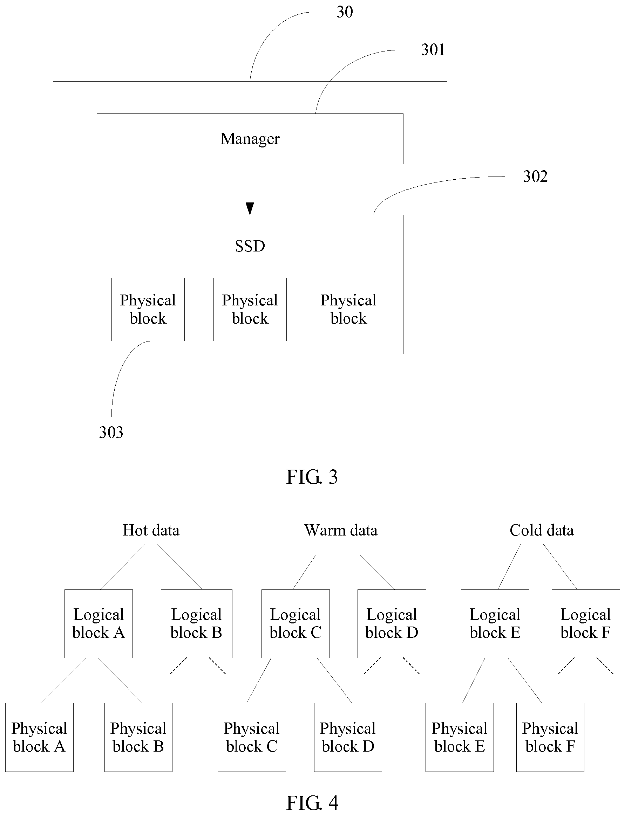

FIG. 3 is an architecture diagram of a first storage system 30 according to an embodiment of the present invention. The first storage system 30 includes a manager 301 and an SSD 302. The SSD 302 includes multiple physical blocks 303. The manager 301 receives a data write request, determines a data category of a to-be-written data page, designates different logical blocks for to-be-written data pages of different data categories, and sends a data write instruction to the SSD 302. Each logical block is corresponding to to-be-written data pages of a same data category, and the data write instruction carries to-be-written data pages corresponding to at least one logical block.

The SSD 302 is configured to receive the data write instruction, and write, according to the data write instruction, the to-be-written data pages corresponding to the at least one logical block to a physical block 303 corresponding to the at least one logical block. To-be-written data pages corresponding to a same logical block are written to at least one physical block 303, and to-be-written data pages written to each physical block 303 are corresponding to a same logical block.

The data write request received by the manager 301 is used to write data to the SSD 302, and the data written to the SSD 302 may be data written to the storage system 30 for the first time, or may be data resulting from updating data already stored in the SSD 302, or may be data transferred from the hard disk drive (not shown in the figure) to the SSD 302.

Because the SSD 302 writes data in pages, after receiving the data write request, the manager 301 further classifies to-be-written data included in the data write request into multiple data pages, and then separately determines a data category of each to-be-written data page.

The manager 301 classifies the data pages into multiple data categories. In this embodiment, the data category is a data access category. The manager classifies the data pages into multiple data access categories according to an access characteristic of the data. The access characteristic may be a quantity of access times of the data page, a reuse distance of the data page, an access frequency of the data page, or a comprehensive characteristic of a quantity of access times and a reuse distance that are of the data page. The quantity of access times is a quantity of times that the to-be-written data page is accessed. The reuse distance is a quantity of data pages separating two accesses to the data page, that is, if a data page is accessed, and an operating system accesses the data page again after accessing seven data pages, a reuse distance of the data page is 7. The access characteristic may further be a quantity of times that the data page is read or written, or the like. The access characteristic may be specifically set according to an actual situation.

In this embodiment, the data access categories include a combination of any two categories or all categories of cold data, hot data, or warm data. For example, as shown in Table 1, when the access characteristic is the quantity of access times, it may be defined that a data page whose quantity of access times (N) is greater than or equal to 15 is hot data, a data page whose quantity of access times is less than 15 and greater than or equal to 5 is warm data, and a data page whose quantity of access times is less than 5 is cold data.

**Table 1: Category defining table**

| **Access characteristic** | **Category** |
|---|---|
| N ≥ 15 | Hot data |
| 5 < N ≤ 15 | Warm data |
| N<5 | Cold data |

The foregoing classification and definition of the data categories are only an example for description, and do not impose any limitation in actual application. For example, classification may be performed according to different sources of data; for example, data from different applications is classified according to different applications.

For the data written to the first storage system for the first time, the manager 301 may predefine a data category of the data. For example, a data category of the data written to the first storage system 301 for the first time may be considered as hot data by default.

In this embodiment, a correspondence between data categories and logical blocks and a correspondence between logical blocks and physical blocks in an SSD are shown in FIG. 4, that is, one data category may be corresponding to at least one logical block, and one logical block can be corresponding to only one data category; similarly, one logical block may be corresponding to at least one physical block 303 in the SSD 302, and one physical block 303 in the SSD 302 can be corresponding to only one logical block. In this way, it may be ensured that data pages recorded into each logical block are of a same data category, and each physical block stores data in only one logical block, that is, stores data pages of a same data category.

The correspondence between data categories and logical blocks that is shown in FIG. 4 may be pre-established by the manager 301, that is, the manager 301 divides logical space of the SSD 302 into multiple logical blocks in advance, and designates at least one logical block for each data category, for example, designates a logical block A and a logical block B for hot data, designates a logical block C and a logical block D for warm data, and designates a logical block E and a logical block F for cold data. In this case, after determining the data category of the to-be-written data page, the manager 301 may designate a logical block corresponding to the determined data category of the to-be-written data page for the to-be-written data page.

Alternatively, the correspondence between data categories and logical blocks that is shown in FIG. 4 is not pre-established by the manager 301. Instead, after the manager 301 determines a data category of each to-be-written data page, if the determined data category of the to-be-written data page has no corresponding logical block, the manager 301 randomly designates one logical block for the to-be-written data page, and then establishes a correspondence between the determined data category of the to-be-written data page and the designated logical block; or if the determined data category has a corresponding logical block, the manager 301 designates the logical block corresponding to the determined data category for the to-be-written data page. In this embodiment, after designating a logical block for the to-be-written data page, the manager 301 is further configured to record, into the logical block designated for the to-be-written data page, a logical block address of each to-be-written data page corresponding to each logical block.

A correspondence between physical blocks 303 and logical blocks is preconfigured in the SSD 302. Each physical block 303 is corresponding to one logical block, and each logical block is corresponding to at least one physical block 303. The correspondence between physical blocks 303 and logical blocks is shown in FIG. 4. In this way, after receiving the data write instruction, the SSD 302 may query the correspondence between physical blocks and logical blocks according to information that is about the at least one logical block and that is in the data write instruction, determine the physical block 303 corresponding to the at least one logical block, and write the to-be-written data pages corresponding to the at least one logical block to the physical block 303 corresponding to the at least one logical block. Data stored in a same physical block 303 may be of a same data category in the foregoing manner.

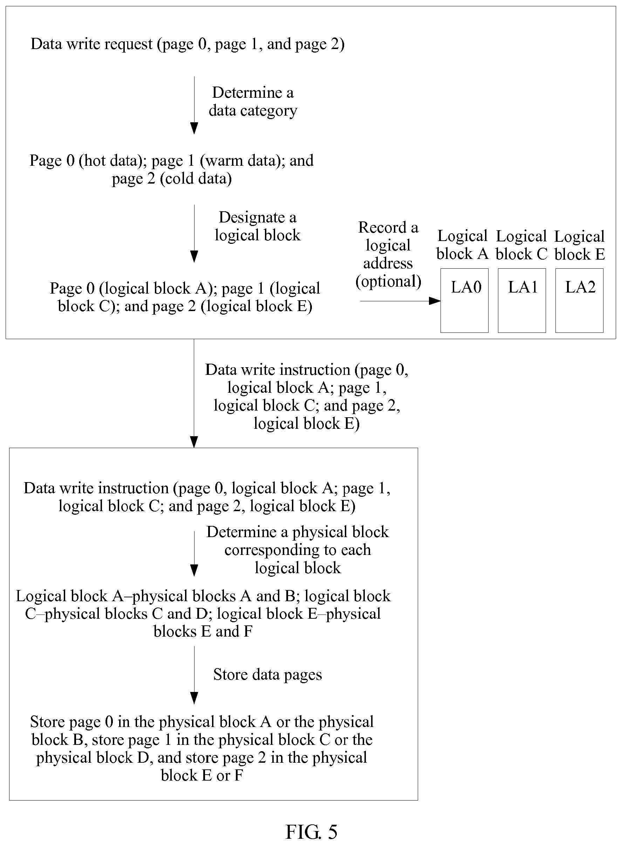

To describe more clearly a process of writing the to-be-written data pages in the data write request to the SSD, an example shown in FIG. 5 is used for detailed description. In the example shown in FIG. 5, the data write request received by the manager 301 includes to-be-written data pages page 0, page 1, and page 2. The manager 301 determines a data category of each of the page 0, the page 1, and the page 2 according to access characteristics of the page 0, the page 1, and the page 2, that is, the page 0 is hot data, the page 1 is warm data, and the page 2 is cold data. After determining the data category of each data page, the manager 301 designates one logical block for each data page according to the category of each data page, where the logical block A is designated for the hot data page 0, the logical block C is designated for the warm data page 1, and the logical block E is designated for the cold data page 2. Optionally, the manager 301 may further record, into each logical block designated for each to-be-written data page, a logical block address of each to-be-written data page corresponding to each logical block, that is, record a logical block address of the page 0 into the logical block A, record a logical block address of the page 1 into the logical block C, and record a logical block address of the page 2 into the logical block E. After the manager 301 designates one logical block for each data page, the manager 301 sends the data write instruction to the SSD 302. The data write instruction includes the to-be-written data pages and information about the logical block of each to-be-written data page (the page 0, the logical block A; the page 1, the logical block C; and the page 2, the logical block E).

After receiving the data write instruction, the SSD 302 determines, according to the information about the logical block of each to-be-written data page and the correspondence between physical blocks and logical blocks that is preset in the SSD 302, a physical block corresponding to each logical block, that is, the logical block A is corresponding to a physical block A and a physical block B; the logical block C is corresponding to a physical block C and a physical block D; and the logical block E is corresponding to a physical block E and a physical block F. Then, the SSD 302 stores the to-be-written data page page 0 in the physical block A or the physical block B, stores the to-be-written data page page 1 in the physical block C or the physical block D, and stores the to-be-written data page page 2 in the physical block E or the physical block F.

By using this embodiment, a same physical block 303 of the SSD 302 may store only data pages of a same data category. In this way, if all data stored in a physical block 303 is hot data whose access frequency is relatively high, a possibility that all data in the physical block 303 is updated is relatively high. After hot data in a physical block that stores hot data is updated, the hot data stored in the physical block before updating becomes invalid data, that is, because a possibility that data in the physical block that stores hot data is updated is high, after data updating, there is a relatively large quantity of invalid pages in the physical block that stores hot data. Therefore, when the physical block is erased, a relatively small quantity of valid pages needs to be migrated, so that write amplification is effectively reduced.

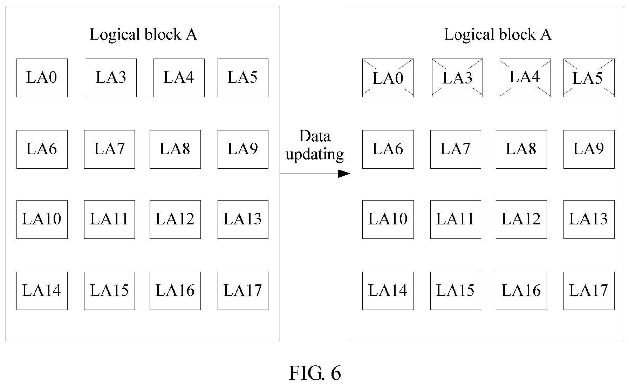

Further, in this embodiment, after designating a logical block for the to-be-written data page, the manager 301 further records, into the logical block designated for the to-be-written data page, a logical block address of each to-be-written data page corresponding to each logical block, and when it is determined that a stored data page needs to be updated, invalidates a logical block address that is of the stored data page and that is recorded in a logical block corresponding to the stored data page. As shown in FIG. 6, if data pages page 0, page 3, page 4, and page 5 that are recorded in the logical block A are updated, logical block addresses LA 0, LA 3, LA 4, and LA 5 that are of the data pages page 0, page 3, page 4, and page 5 and that are recorded in the logical block A are invalidated. In this way, by recording a logical block address of each data page into a logical block, the manager 301 can learn a category and a state of a data page stored inside the SSD, and can implement management of the data page stored in the SSD 302.

Further, in this embodiment, the manager 301 may control erasure of the physical block 303 in the SSD 302. Specifically, the manager 301 determines a to-be-erased logical block and sends an erase instruction to the SSD 302. The erase instruction carries information about the to-be-erased logical block.

The SSD 302 receives the erase instruction, determines a to-be-erased physical block 303 according to the information that is about the to-be-erased logical block and that is in the erase instruction and the correspondence between physical blocks 303 and logical blocks, and erases the to-be-erased physical block 303.

In this embodiment, the manager 301 determines the to-be-erased logical block according to data pages corresponding to each logical block.

Further, the manager 301 selects, as the to-be-erased logical block, a logical block whose data category is hot data or a logical block that has a large quantity of invalid logical block addresses.

Alternatively, the manager 301 selects, as the to-be-erased logical block, a logical block whose data category is cold data.

Further, in this embodiment, before sending the erase instruction to the SSD 302, the manager 301 further determines a to-be-migrated data page in the to-be-erased logical block according to a preset migration policy, and sends a data migration instruction to the SSD 302. The data migration instruction carries information about the to-be-migrated data page.

The SSD 302 migrates the to-be-migrated data page in the SSD 302 according to the data migration instruction.

The manager 301 determines a data page in the to-be-erased logical block as the to-be-migrated data page, where a current data category of the data page is hot data, and a logical block address of the data page is valid.

The manager 301 designates a logical block for the to-be-written data page according to a data category that is of the to-be-written data page at a time when data is written. However, the data category of the data page changes with the access characteristic; therefore, after the data page is recorded into the logical block, the data category of the data page recorded into the logical block changes because of a subsequent change of the access characteristic. For example, if a data category of a data page is hot data at a time when the data page is written, and the data page is never accessed after being designated to a logical block corresponding to hot data, the data page becomes cold data; or a data category of a data page is cold data at a time when the data page is written, and the data page becomes hot data after being designated to a logical block corresponding to cold data. Therefore, at a time when erasure is performed on the to-be-erased logical block, a data category of a data page recorded in the to-be-erased logical block may be different from a data category that is at a time when the data page is just recorded into the to-be-erased logical block. Therefore, when erasing is performed on the to-be-erased logical block, a category of the data page in the to-be-erased logical block may be further determined, so that only a data page of a specific category, for example, hot data or warm data, is migrated. In this way, a quantity of data migration may be further reduced, and write amplification is further reduced.

During data migration, the information that is about the to-be-migrated data page and that is carried in the data migration instruction is a logical block address of the to-be-migrated data page. After receiving the data migration instruction, the SSD 302 finds the to-be-migrated data page in the to-be-erased physical block according to the logical block address that is of the to-be-migrated data page and that is in the data migration instruction, and then migrates the to-be-migrated data page.

Further, after determining the to-be-migrated data page in the to-be-erased logical block, the manager 301 further records the logical block address of the to-be-migrated data page into a logical block corresponding to the data category of the to-be-migrated data page. Correspondingly, the data migration instruction sent by the manager 301 to the SSD 302 further carries information about the logical block corresponding to the data category of the to-be-migrated data page. The SSD 302 determines, according to the information that is about the logical block corresponding to the data category of the to-be-migrated data page and that is carried in the migration instruction, a physical block corresponding to the logical block corresponding to the data category of the to-be-migrated data page, and migrates the to-be-migrated data page to the physical block corresponding to the logical block corresponding to the data category of the to-be-migrated data page.

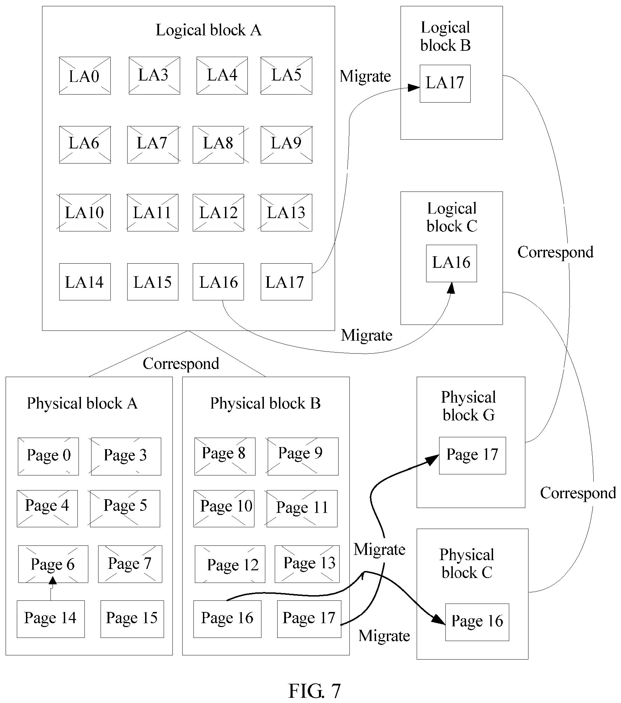

As shown in FIG. 7, the logical block A is selected as the to-be-erased logical block because of a relatively large quantity of invalid logical pages, but there are also valid logical block addresses LA 14, LA 15, LA 16, and LA 17 in the logical block A, where data categories corresponding to the valid logical block addresses LA 14 and LA 15 are cold data, and data categories corresponding to the LA 16 and the LA 17 are respectively warm data and hot data. In this case, it may be determined that to-be-migrated data pages are data pages corresponding to the valid logical block addresses LA 16 and LA 17. The valid logical block address LA 16 is migrated to the logical block C corresponding to warm data, and the valid logical block address LA 17 is migrated to the logical block B corresponding to hot data. Then, the manager 301 sends a data migration instruction to the SSD 302, where the data migration instruction carries the logical block addresses LA 16 and LA 17 of the to-be-migrated data pages page 16 and page 17; and records information about logical blocks respectively corresponding to the LA 16 and the LA 17, that is, the logical block C and the logical block B.

After receiving the data migration instruction, the SSD 302 finds, according to the logical block addresses LA 16 and LA 17, the to-be-migrated data pages page 16 and page 17 in the to-be-erased physical block B corresponding to the to-be-erased logical block A; then migrates the to-be-migrated data page page 16 to a physical block C corresponding to the logical block in which the logical block address LA 16 is recorded, and migrates the to-be-migrated data page page 17 to a physical block G corresponding to the logical block in which the logical block address LA 17 is recorded. After data migration is completed, the SSD 302 may erase the to-be-erased physical block A and the to-be-erased physical block B.

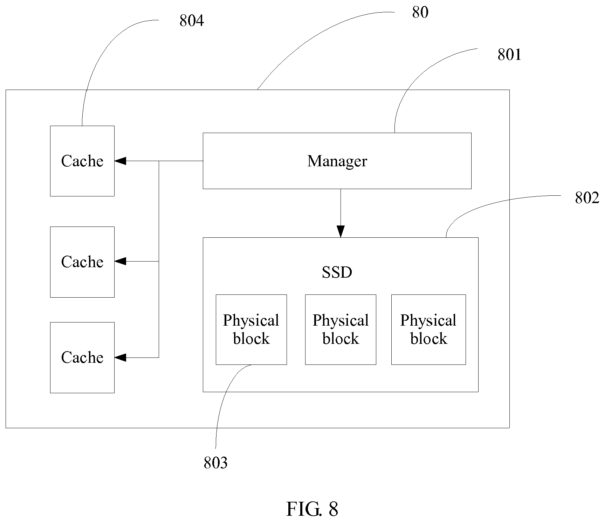

FIG. 8 is an architecture diagram of a second storage system 80 according to another embodiment of the present invention. The second storage system 80 includes a manager 801, an SSD 802, and at least one cache 804. The SSD 802 includes multiple physical blocks 803.

After receiving a data write request, the manager 801 writes to-be-written data pages of different data categories to different caches 804, where to-be-written data pages written to each cache 804 are of a same data category; when any cache 804 is fully written, designates one logical block for data pages that are of a same category and that are in the fully written cache 804; and sends a data write instruction to the SSD 802. The data write instruction carries information about the logical block designated for the data pages in the fully written cache 804 and the data pages in the fully written cache 804. A capacity of each cache is less than or equal to a capacity of each logical block.

After receiving the data write instruction, according to the data write instruction, the SSD 802 allocates a physical block 803 to the logical block designated for the data pages in the fully written cache 804, and writes the data pages in the fully written cache 804 to the allocated physical block 803. The allocated physical block 803 is an idle physical block 803 in the SSD, and the idle physical block 803 is subsequently marked as non-idle. A total capacity of the allocated physical block 803 is greater than or equal to a capacity of the logical block designated for the data pages in the fully written cache 804.

In this embodiment, the idle physical block 803 may be marked as non-idle after the physical block 803 is allocated, or may be marked as non-idle after the data pages in the cache 804 are written to the physical block 803.

In the second storage system 80, a manner for classifying a data page category, a manner for establishing a correspondence between data categories and logical blocks, and a manner for designating a logical block for a to-be-written data page are the same as those in the first storage system 30, and details are not described herein.

In the second storage system 80, one cache is set for data pages of each data category. When the data write instruction is received, to-be-written data pages of a same data category are first written to a same cache, and then the data write instruction is sent to the SSD, to instruct the SSD to store, in a same physical block, data in the fully written cache. In this way, a same physical block 803 stores data of a same data category, and a data writing granularity can be increased, so that data writing efficiency is improved.

In the second storage system 80, erasure of data in a physical block 803, and a manner for migrating data in a to-be-erased physical block 803 before erasure are the same as those in the first storage system 30, and details are not described herein.

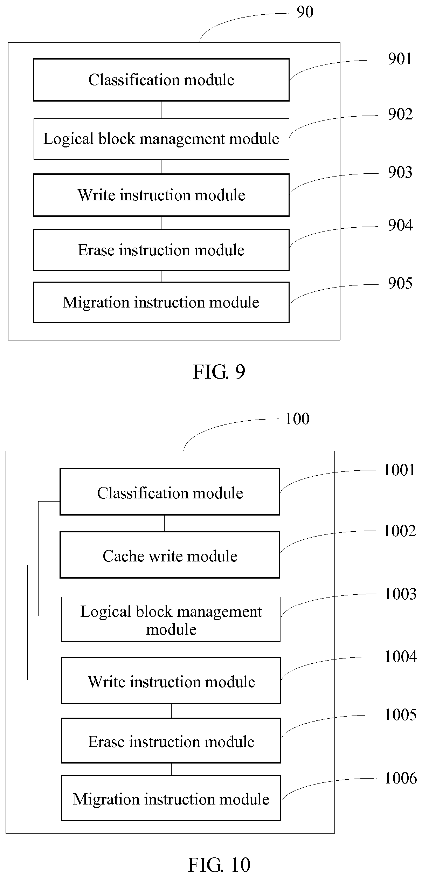

FIG. 9 is a block diagram of a first storage management apparatus 90 according to an embodiment of the present invention. The first storage management apparatus 90 is applied to a storage system, the storage system includes an SSD, and the SSD includes multiple physical blocks. The first storage management apparatus 90 includes a classification module 901, a logical block management module 902, a write instruction module 903, an erase instruction module 904, and a migration instruction module 905.

The classification module 901 is configured to receive a data write request and determine a data category of a to-be-written data page.

A manner for classifying data by the classification module 901 is the same as the manner for classifying data by the manager 301 in the first storage system 30, and details are not described herein.

The logical block management module 902 is configured to designate different logical blocks for to-be-written data pages of different data categories according to a classification result of the classification module 901. Each designated logical block is corresponding to to-be-written data pages of a same data category.

A manner for designating different logical blocks for to-be-written data pages of different data categories by the logical block management module 902 is the same as the manner for designating different logical blocks for to-be-written data pages of different data categories by the manager 301 in the first storage system 30, and details are not described herein.

The write instruction module 903 is configured to send a data write instruction to the SSD according to the logical blocks designated by the logical block management module 902 for the to-be-written data pages. The data write instruction carries to-be-written data pages corresponding to at least one designated logical block, and the data write instruction is used to instruct the SSD to write, according to the data write instruction, the to-be-written data page corresponding to the at least one designated logical block to a physical block corresponding to the at least one designated logical block. To-be-written data pages corresponding to a same logical block are written to at least one physical block, and to-be-written data pages written to each physical block are corresponding to a same logical block.

The data write instruction further instructs the SSD to: query, according to information that is about the at least one designated logical block and that is in the data write instruction, a correspondence between physical blocks and logical blocks that is set in the SSD, determine the physical block corresponding to the at least one designated logical block, and write the to-be-written data page corresponding to the at least one designated logical block to the physical block corresponding to the at least one designated logical block.

After designating the different logical blocks for the to-be-written data pages of different data categories, the logical block management module 902 is further configured to record, into the at least one designated logical block, a logical block address of each to-be-written data page corresponding to the at least one designated logical block, and record a correspondence between the at least one designated logical block and a data category of a data page corresponding to the at least one designated logical block.

The erase instruction module 904 is configured to determine a to-be-erased logical block and send an erase instruction to the SSD. The erase instruction carries information about the to-be-erased logical block, and the erase instruction is used to instruct the SSD to determine a to-be-erased physical block according to the information that is about the to-be-erased logical block and that is in the erase instruction and the correspondence between physical blocks and logical blocks that is set in the SSD, and to erase the to-be-erased physical block.

Further, when it is determined that a stored data page needs to be updated, the logical block management module 902 invalidates a logical block address that is of the stored data page and that is recorded into a logical block corresponding to the stored data page.

The erase instruction module 904 determines the to-be-erased logical block according to data pages corresponding to each logical block.

Further, the erase instruction module 904 selects, as the to-be-erased logical block, a logical block whose data category is hot data or a logical block that has a large quantity of invalid logical block addresses.

Alternatively, the erase instruction module 904 selects, as the to-be-erased logical block, a logical block whose data category is cold data.

Before the erase instruction module 904 sends the erase instruction to the SSD, the migration instruction module 905 is configured to determine a to-be-migrated data page in the to-be-erased logical block according to a preset migration policy, and send a data migration instruction to the SSD. The data migration instruction carries information about the to-be-migrated data page, and the data migration instruction is used to instruct the SSD to migrate the to-be-migrated data page in the SSD.

The migration instruction module 905 determines a data page in the to-be-erased logical block as the to-be-migrated data page, where a current data category of the data page is hot data, and a logical block address of the data page is valid.

FIG. 10 is a block diagram of a second storage management apparatus 100 according to another embodiment of the present invention. The second storage management apparatus 100 is applied to a storage system, the storage system includes an SSD and at least one cache, and the SSD includes multiple physical blocks. The storage management apparatus 100 includes a classification module 1001, a cache write module 1002, a logical block management module 1003, a write instruction module 1004, an erase instruction module 1005, and a migration instruction module 1006.

The classification module 1001 is configured to receive a data write request and determine a data category of a to-be-written data page.

The cache write module 1002 is configured to write to-be-written data pages of different data categories to different caches according to a classification result of the classification module 1001. To-be-written data pages of a same data category are written to a same cache, and a capacity of each cache is less than or equal to a capacity of each logical block. The logical block management module 1003 is configured to designate, according to the classification result of the classification module 1001, one logical block for data pages that are of a same data category and that are in each fully written cache.

When the cache is fully written by the cache write module 1002, the write instruction module 1004 is configured to send a data write instruction to the SSD according to a logical block designated by the logical block management module 1003 for the to-be-written data pages. The data write instruction carries information about at least one designated logical block and a data page corresponding to the at least one designated logical block.

The data write instruction is used to instruct the SSD to allocate a physical block to the at least one designated logical block, and to write the data page corresponding to the at least one designated logical block to the allocated physical block. The allocated physical block is an idle physical block in the SSD, and the idle physical block is marked as non-idle subsequently. A total capacity of the allocated physical block is greater than or equal to a capacity of the at least one designated logical block. In this embodiment, the idle physical block may be marked as non-idle after the physical block is allocated, or may be marked as non-idle after a data page in the cache are written to the physical block.

Functions executed by the erase instruction module 1005 and the migration instruction module 1006 are the same as functions executed by the erase instruction module 904 and the migration instruction module 905 that are in the first storage management apparatus 90, and details are not described herein.

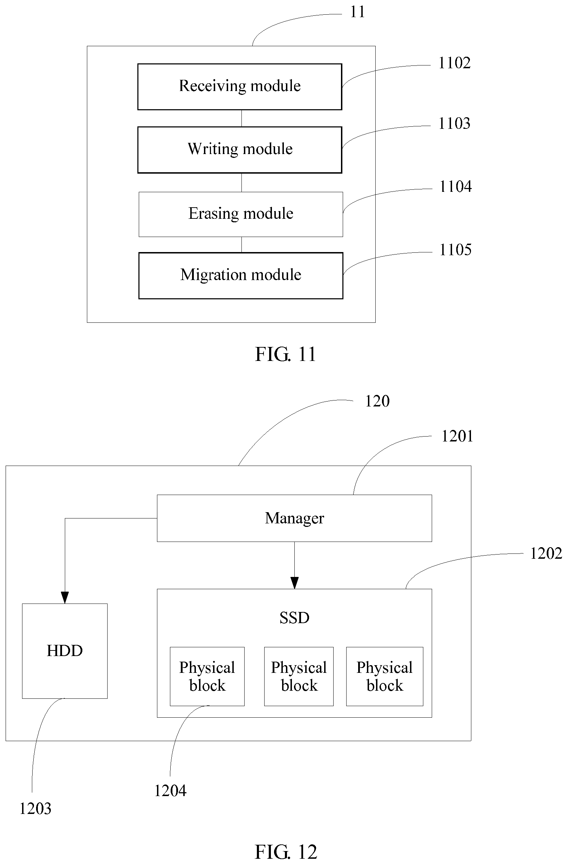

FIG. 11 is a block diagram of an SSD 11 according to an embodiment of the present invention. The SSD 11 may be applied to a storage system, and the storage system includes a manager. The SSD 11 includes a receiving module 1102, a writing module 1103, an erasing module 1104, and a migration module 1105.

The receiving module 1102 is configured to receive a data write instruction sent by the manager. The data write instruction carries to-be-written data pages corresponding to at least one designated logical block and information about the at least one designated logical block. The data write instruction is sent by the manager after the manager determines a data category of the to-be-written data pages and designates different logical blocks for to-be-written data pages of different data categories. Each designated logical block is corresponding to to-be-written data pages of a same data category.

The writing module 1103 is configured to: query, according to the information that is about the at least one designated logical block and that is in the data write instruction, a correspondence between physical blocks and logical blocks that is set in the SSD 11, determine a physical block corresponding to the at least one designated logical block, and write the to-be-written data page corresponding to the at least one designated logical block to the physical block corresponding to the at least one designated logical block. Each physical block is corresponding to one logical block, and each logical block is corresponding to at least one physical block.

The receiving module 1102 is further configured to receive an erase instruction sent by the manager. The erase instruction is sent by the manager after the manager determines a to-be-erased logical block, and the erase instruction carries information about the to-be-erased logical block.

The erasing module 1104 is configured to determine a to-be-erased physical block according to the information that is about the to-be-erased logical block and that is in the erase instruction and the correspondence between physical blocks and logical blocks, and erase the to-be-erased physical block.

The receiving module 1102 is further configured to receive a data migration instruction sent by the manager. The data migration instruction is sent by the manager after the manager determines a to-be-migrated data page in the to-be-erased logical block according to a preset migration policy, and the data migration instruction carries information about the to-be-migrated data page.

The migration module 1105 is configured to migrate the to-be-migrated data page in the SSD according to the data migration instruction.

In a system that includes a cache and a manager, the SSD 11 may be further configured to receive a data write instruction. The data write instruction is sent by the manager after the manager writes to-be-written data pages of different data categories to different caches, and when a cache is fully written, designates at least one logical block for data pages of a same data category in each fully written cache. To-be-written data pages written to each cache are of a same data category.

After the receiving module 1102 receives the data write instruction, according to the data write instruction, the writing module 1103 allocates a physical block to the at least one designated logical block and writes a data page corresponding to the at least one designated logical block to the allocated physical block. The allocated physical block is an idle physical block in the SSD 11, and the idle physical block is marked as non-idle subsequently. A total capacity of the allocated physical block is greater than or equal to a capacity of the at least one designated logical block.

The writing module 1103 is further configured to record the correspondence between physical blocks and logical blocks according to the information that is about the at least one designated logical block and that is in the data write instruction and information about the physical block allocated to the at least one designated logical block.

FIG. 12 is a structural diagram of a hybrid storage apparatus 120 according to an embodiment of the present invention. The hybrid storage apparatus 12 includes a manager 1201, an SSD 1202, and an HDD 1203. The SSD 1202 is used as a cache of the HDD, and the SSD 1202 includes multiple physical blocks 1204.

A function executed by the manager 1201 is the same as the function executed by the manager 301 in the first storage system 30 or the manager 801 in the second storage system 80; a function executed by the SSD 1202 is the same as the function executed by the SSD 302 in the first storage system 30 or the SSD 802 in the second storage system 80. Details are not described herein.

An embodiment of the present invention further provides a storage management method. The storage management method may be applied to a storage management system. The storage management system includes a manager and an SSD, and the SSD includes multiple physical blocks. The storage management method includes two parts: A first part is a method for writing data to the SSD by the manager, and a second part is a method for controlling, by the manager, the SSD to perform data erasure.

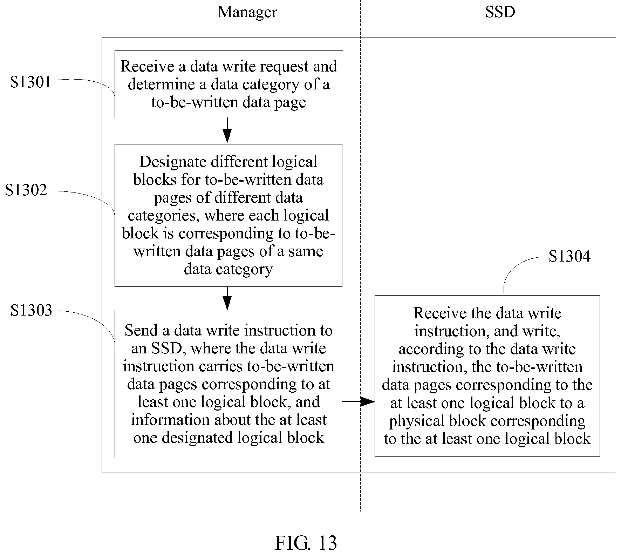

FIG. 13 is a flowchart of a method for writing data to the SSD by the manager.

Step S1301: The manager receives a data write request and determines a data category of a to-be-written data page.

Step S1302: The manager designates different logical blocks for to-be-written data pages of different data categories, where each logical block is corresponding to to-be-written data pages of a same data category.

Step S1303: The manager sends a data write instruction to the SSD, where the data write instruction carries to-be-written data pages corresponding to at least one logical block, and information about the at least one designated logical block.

Step S1304: The SSD receives the data write instruction, and writes, according to the data write instruction, the to-be-written data pages corresponding to the at least one logical block to a physical block corresponding to the at least one logical block, where to-be-written data pages corresponding to a same logical block are written to at least one physical block, and to-be-written data pages written to each physical block are corresponding to a same logical block.

After step S1302, the method may further include: the manager records, into the at least one designated logical block, a logical block address of each to-be-written data page corresponding to the at least one designated logical block, and records a correspondence between the at least one designated logical block and a data category of a data page corresponding to the at least one designated logical block.

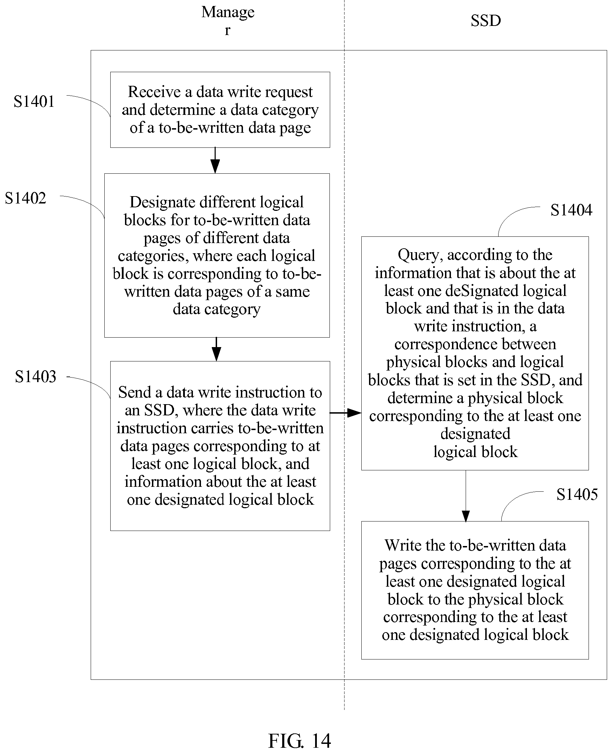

FIG. 14 is a flowchart of a first specific implementation method for writing data to the SSD by the manager.

Step S1401: The manager receives a data write request and determines a data category of a to-be-written data page.

Step S1402: The manager designates different logical blocks for to-be-written data pages of different data categories, where each logical block is corresponding to to-be-written data pages of a same data category.

Step S1403: The manager sends a data write instruction to the SSD, where the data write instruction carries to-be-written data pages corresponding to at least one logical block, and information about the at least one designated logical block.

Step S1404: The SSD queries, according to the information that is about the at least one designated logical block and that is in the data write instruction, a correspondence between physical blocks and logical blocks that is set in the SSD, and determines a physical block corresponding to the at least one designated logical block.

Step S1405: The SSD writes the to-be-written data page corresponding to the at least one designated logical block to the physical block corresponding to the at least one designated logical block.

After step S1402, the method may further include: the manager records, into the at least one designated logical block, a logical block address of each to-be-written data page corresponding to the at least one designated logical block, and records a correspondence between the at least one designated logical block and a data category of a data page corresponding to the at least one designated logical block.

The storage management system to which the storage management method is applied further includes multiple caches. In the storage management system that includes the multiple caches, the manager writes data to the SSD by using a second method.

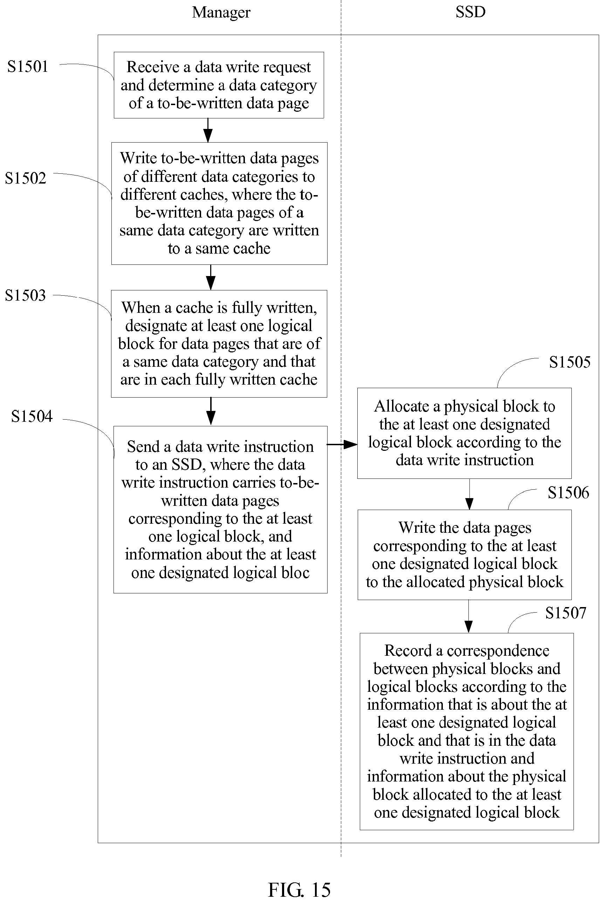

FIG. 15 is a flowchart of a second specific implementation method for writing data to the SSD by the manager.

Step S1501: The manager receives a data write request and determines a data category of a to-be-written data page.

Step S1502: The manager writes to-be-written data pages of different data categories to different caches, where the to-be-written data pages of a same data category are written to a same cache.

Step S1503: When a cache is fully written, the manager designates at least one logical block for data pages that are of a same data category and that are in each fully written cache.

Step S1504: The manager sends a data write instruction to the SSD, where the data write instruction carries the to-be-written data pages corresponding to the at least one logical block, and information about the at least one designated logical block.

Step S1505: The SSD allocates a physical block to the at least one designated logical block according to the data write instruction.

Step S1506: The SSD writes a data page corresponding to the at least one designated logical block to the allocated physical block.

Step S1507: The SSD records a correspondence between physical blocks and logical blocks according to the information that is about the at least one designated logical block and that is in the data write instruction and information about the physical block allocated to the at least one designated logical block.

After step S1503, the method may further include: the manager records, into the at least one designated logical block, a logical block address of each to-be-written data page corresponding to the at least one designated logical block, and records a correspondence between the at least one designated logical block and a data category of the data page corresponding to the at least one designated logical block.

The storage management method further includes: when it is determined that a stored data page needs to be updated, the manager invalidates a logical block address that is of the stored data page and that is recorded into a logical block corresponding to the stored data page.

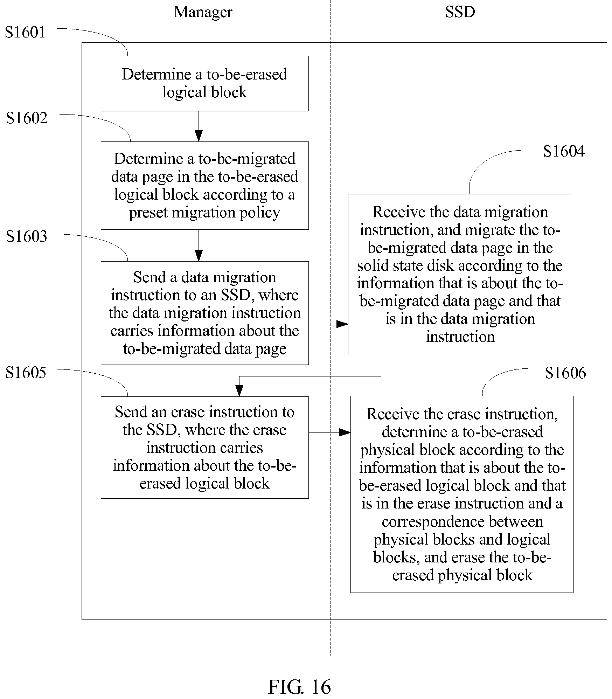

FIG. 16 is a flowchart of a method for controlling, by the manager, the SSD to perform data erasure.

Step S1601: The manager determines a to-be-erased logical block.

Step S1602: The manager determines a to-be-migrated data page in the to-be-erased logical block according to a preset migration policy.

Step S1603: The manager sends a data migration instruction to the SSD, where the data migration instruction carries information about the to-be-migrated data page.

Step S1604: The SSD receives the data migration instruction, and migrates the to-be-migrated data page in the SSD according to the information that is about the to-be-migrated data page and that is in the data migration instruction.

Step S1605: The manager sends an erase instruction to the SSD, where the erase instruction carries information about the to-be-erased logical block.

Step 1606: The SSD receives the erase instruction, determines a to-be-erased physical block according to the information that is about the to-be-erased logical block and that is in the erase instruction and a correspondence between physical blocks and logical blocks, and erases the to-be-erased physical block.

The manager may determine the to-be-erased logical block in two manners: Manner 1: determining the to-be-erased logical block according to a quantity of invalid logical block addresses in a designated logical block, where a quantity of invalid logical block addresses included in the to-be-erased logical block is greater than a preset value; and Manner 2: according to a correspondence between a designated logical block and a data category of data pages corresponding to the designated logical block, selecting, as the to-be-erased logical block, a logical block whose data category is cold data.

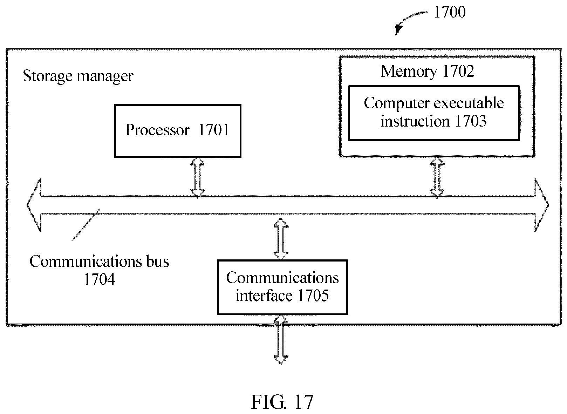

FIG. 17 is a schematic diagram of a structural composition of a storage manager according to an embodiment of the present invention. The storage manager in this embodiment of the present invention may include:
a processor 1701, a memory 1702, a system bus 1704, and a communications interface 1705. The processor 1701, the memory 1702, and the communications interface 1705 are connected by using the system bus 1704, and complete communication with each other.

The processor 1701 may be a single-core or multi-core central processing unit, or an application-specific integrated circuit, or one or more integrated circuits configured to implement this embodiment of the present invention.

The memory 1702 may be a high-speed RAM memory, or may be a non-volatile memory (non-volatile memory), such as at least one magnetic disk storage.

The memory 1702 is configured to store a computer executable instruction 1703. Specifically, the computer executable instruction 1703 may include program code.

When the storage manager runs, the processor 1701 may execute any one of the method procedures in FIG. 13 to FIG. 16 by executing the computer executable instruction 1703.

An embodiment of the present invention further provides a computer readable medium, including a computer executable instruction. When a processor of a computer executes the computer executable instruction, the computer executes any one of the methods in FIG. 13 to FIG. 16.

In the present invention, a function executed by an SSD improves an FTL of the SSD, and is executed by the FTL of the SSD, or may be an independent function module built into the SSD.

Persons of ordinary skill in the art may understand that all or a part of the steps of the methods in the foregoing embodiments may be implemented by a program instructing related hardware. The program may be stored in a computer readable storage medium. The storage medium may include: a ROM, a RAM, a magnetic disk, or an optical disc.

The storage system, the storage management apparatus, the storage, the hybrid storage apparatus, and the storage management method provided by the present invention are described in detail above.

## Claims

1. A storage system comprising:
a storage; and
a storage management apparatus for managing the storage,
wherein the storage management apparatus comprises:
a classification module (901), configured to receive a data write request comprising a to-be-written data page and determine a data category of the to-be-written data page;
a logical block management module (902), configured to designate different logical blocks for to-be-written data pages of different data categories according to a classification result of the classification module; and
a write instruction module (903), configured to send a data write instruction to the storage according to the logical blocks designated by the logical block management module for the to-be-written data pages, wherein the data write instruction carries the to-be-written data pages and indicates, for each data page, a logical block designated to the respective data page, and the data write instruction is used to instruct the storage to write the to-be-written data pages to at least one physical block corresponding to the at least one logical block, wherein to-be-written data pages corresponding to a logical block are written to at least one physical block, and to-be-written data pages written to each physical block are corresponding to only one logical block; and
wherein the storage comprises:
multiple physical blocks;
a receiving module (1102), configured to receive a data write instruction, wherein the data write instruction carries to-be-written data pages corresponding to at least one logical block and indicates, for each data page, a logical block designated to the respective data page according to a data category of the to-be-written data pages; and
a writing module (1103), configured to write, according to the data write instruction, the to-be-written data pages to a physical block corresponding to the at least one logical block, wherein to-be-written data pages corresponding to a logical block are written to at least one physical block, and to-be-written data pages written to each physical block are corresponding to only one logical block.

2. The storage system according to claim 1, wherein the data write instruction further carries information about the at least one logical block; and
the data write instruction is specifically used to instruct the storage to: query, according to the information about the at least one logical block, a correspondence storage between physical blocks and logical blocks that is preset in the storage to determine a physical block corresponding to the at least one logical block, and write the to-be-written data pages corresponding to the at least one logical block to the physical block corresponding to the at least one logical block.

3. The storage system according to claim 1, wherein the storage management apparatus further comprises:
a cache write module (1002), configured to write the to-be-written data pages of different data categories to different caches according to the classification result of the classification module, wherein the to-be-written data pages of a same data category are written to a same cache, and a capacity of each cache is less than or equal to a capacity of each logical block; wherein
the logical block management module (1003) is configured to designate one logical block for data pages that are of a same data category and that are in each fully written cache; wherein the data write instruction further carries information about the at least one logical block, and the data write instruction is further used to instruct the storage to allocate a physical block to the at least one logical block before writing the to-be written data pages , and wherein a physical block allocated to each logical block of the at least one logical block is an idle physical block in the storage, and the idle physical block is marked as non-idle after being allocated; a total capacity of the physical block allocated to each logical block of the at least one logical block is greater than or equal to a capacity of each logical block in the at least one logical block.

4. The storage system according to claim 2 or 3, wherein the logical block management module (1003) is further configured to record, into the at least one logical block, a logical block address of each to-be-written data page corresponding to the at least one logical block, and record a data category of the data pages corresponding to the at least one logical block.

5. The storage system according to claim 4, wherein the storage management apparatus further comprises: an erase instruction module (1005), configured to determine a to-be-erased logical block according to data pages corresponding to each logical block, and send an erase instruction to the storage, wherein the erase instruction carries information about the to-be-erased logical block, and the erase instruction is used to instruct the storage to determine a to-be-erased physical block according to the information that is about the to-be-erased logical block and that is in the erase instruction and the storage correspondence between physical blocks and logical blocks that is set in the storage, and to erase the to-be-erased physical block.

6. The storage system according to claim 5, wherein the data categories are cold data and hot data that are determined according to data access frequency; the logical block management module (1003) is further configured to: when a stored data page needs to be updated, invalidate a logical block address that is of the stored data page and that is recorded into a logical block corresponding to the stored data page; and
that an erase instruction module is configured to determine a to-be-erased logical block comprises: selecting, as the to-be-erased logical block, a logical block whose data category is hot data or a logical block that has a large quantity of invalid logical block addresses.

7. The storage system according to claim 5, wherein the data categories are cold data and hot data that are determined according to data access frequency; that the erase instruction module is configured to determine a to-be-erased logical block specifically comprises: selecting, as the to-be-erased logical block, a logical block whose data category is cold data; and
the erase instruction module (1005) is further configured to add a garbage collection forbidding indication into the erase instruction.

8. The storage system according to any one of claims 5 to 7, wherein the storage management apparatus further comprises a migration instruction module (1006); before the erase instruction module (1005) sends the erase instruction to the storage, the migration instruction module is configured to determine a to-be-migrated data page in the to-be-erased logical block according to a preset migration policy, and send a data migration instruction to the storage, wherein the data migration instruction carries information about the to-be-migrated data page, and the data migration instruction is used to instruct the storage to migrate the to-be-migrated data page in the storage.

9. The storage system according to claim 8, wherein that the migration instruction module (1006) determines a to-be-migrated data page in the to-be-erased logical block according to a preset migration policy specifically comprises: determining a data page in the to-be-erased logical block as the to-be-migrated data page, wherein a current data category of the data page is hot data, and a logical block address of the data page is valid.

10. The storage system according to any one of claims 1 to 9, wherein the storage comprises a preset correspondence between physical blocks and logical blocks, wherein each physical block is corresponding to one logical block, and each logical block is corresponding to at least one physical block;
the data write instruction received by the receiving module further carries information about the at least one logical block; and
after the receiving module (1102) receives the data write instruction, the writing module is specifically configured to: query, according to the information that is about the at least one logical block and that is in the data write instruction, a correspondence between physical blocks and logical blocks that is preconfigured by the configuration module, determine the physical block corresponding to the at least one logical block, and write the to-be-written data pages corresponding to the at least one logical block to the physical block corresponding to the at least one logical block.

11. The storage system according to any one of claims 1 to 9, wherein:
the data write instruction is sent by the manager after the manager writes the to-be-written data pages of different data categories into different caches and designates at least one logical block for data pages that are of a same data category and that are in each fully written cache, wherein the to-be-written data pages written to each cache are of a same data category; and
after the receiving module (1102) receives the data write instruction, the writing module is specifically configured to: according to the data write instruction, allocate a physical block to the at least one logical block and write the data pages corresponding to the at least one logical block to the allocated physical block, wherein a physical block allocated to each logical block of the at least one logical block is an idle physical block in the storage, and the idle physical block is marked as non-idle after being allocated; a total capacity of the physical block allocated to each logical block of the at least one logical block is greater than or equal to a capacity of each logical block in the at least one logical block.

12. The storage system according to claim 11, wherein the writing module (1103) is further configured to record a correspondence between physical blocks and logical blocks according to the information that is about the at least one logical block and that is in the data write instruction and information about the physical block allocated to the at least one logical block.

13. The storage system according to claim 12, wherein the receiving module (1102) is further configured to receive an erase instruction sent by the manager, wherein the erase instruction is sent by the manager after the manager determines a to-be-erased logical block, and the erase instruction carries information about the to-be-erased logical block; and
the storage further comprises: an erasing module (1104), configured to determine a to-be-erased physical block according to the information that is about the to-be-erased logical block and that is in the erase instruction and the correspondence between physical blocks and logical blocks, and erase the to-be-erased physical block.

14. The storage system according to claim 13, wherein the receiving module (1102) is further configured to receive a data migration instruction sent by the manager, wherein the data migration instruction is sent by the manager after the manager determines a to-be-migrated data page in the to-be-erased logical block according to a preset migration policy, and the data migration instruction carries information about the to-be-migrated data page; and
the storage further comprises a migration module (1105), configured to migrate the to-be-migrated data page in the storage according to the data migration instruction.

15. A hybrid storage apparatus, comprising a hard disk drive and the storage system according to any one of claims 1 to 14, wherein the storage is used as a cache of the magnetic disk storage.

16. A storage management method, applied to a storage system that comprises a storage and a storage management apparatus for managing the storage, wherein the storage comprises multiple physical blocks, and the method comprises:
receiving (S1301), by the storage management apparatus, a data write request comprising a to-be-written data page and determining a data category of the to-be-written data page;
designating (S1302), by the storage management apparatus, a logical block for the to-be-written data page, wherein the designated logical block is corresponding to to-be-written data pages of a same data category;
sending (S1303), by the storage management apparatus, a data write instruction to the storage, wherein the data write instruction carries the to-be-written data pages and indicates, for each data page, a logical block designated to the respective data page, and the data write instruction is used to instruct the storage to write, according to the data write instruction, the to-be-written data pages to at least one physical block corresponding to the at least one logical block, wherein to-be-written data pages corresponding to a logical block are written to at least one physical block, and to-be-written data pages written to each physical block are corresponding to only one logical block;
receiving, by the storage, the data write instruction from the storage management apparatus, wherein the data write instruction carries to-be-written data pages and indicates, for each data page, a logical block designated to the respective data page, wherein each logical block is corresponding to to-be-written data pages of a same data category; and
writing, by the storage, according to the data write instruction, the to-be-written data pages to at least one physical block corresponding to the at least one logical block, wherein to-be-written data pages corresponding to a logical block are written to at least one physical block, and to-be-written data pages written to each physical block are corresponding to only one logical block.

17. The storage management method according to claim 16, wherein the data write instruction further carries information about the at least one logical block; and
the data write instruction further instructs the storage to: query, according to the information that is about the at least one logical block and that is in the data write instruction, a correspondence between physical blocks and logical blocks that is preset in the storage to determine a physical block corresponding to the at least one logical block, and write the to-be-written data pages corresponding to the at least one logical block to the physical block corresponding to the at least one logical block.

18. The storage management method according to claim 16, further comprising:
writing (S1502) the to-be-written data pages of different data categories into different caches, wherein the to-be-written data pages of a same data category are written to a same cache, and a capacity of each cache is less than or equal to a capacity of each logical block;
wherein one logical block is designated for the to-be-written data pages that are fully written in a cache; wherein the data write instruction further carries information about the at least one logical block , and the data write instruction is further used to instruct the storage to allocate a physical block to the at least one logical block before writing the to-be written data pages, and
wherein a physical block allocated to each logical block of the at least one logical block is an idle physical block in the storage, and the idle physical block is marked as non-idle after being allocated; a total capacity of the physical block allocated to each logical block of the at least one logical block is greater than or equal to a capacity of each logical block in the at least one logical block.

19. The storage management method according to claim 17 or 18, after the designating different logical blocks for to-be-written data pages of different data categories, further comprising: recording, into the at least one logical block, a logical block address of each to-be-written data page corresponding to the at least one logical block.

20. The storage management method according to claim 19, further comprising:
determining a to-be-erased logical block according to data pages corresponding to each logical block, and sending an erase instruction to the storage, wherein the erase instruction carries information about the to-be-erased logical block, and the erase instruction is used to instruct the storage to determine a to-be-erased physical block according to the information that is about the to-be-erased logical block and that is in the erase instruction and the storage correspondence between physical blocks and logical blocks that is set in the storage, and to erase the to-be-erased physical block.

21. The storage management method according to claim 20, wherein the data categories are cold data and hot data that are determined according to data access frequency; the method further comprises: when a stored data page needs to be updated, invalidating a logical address that is of the stored data page and that is recorded in a logical block corresponding to the stored data page; and
the determining a to-be-erased logical block comprises: selecting a logical block whose data category is hot data or a logical block that has a large quantity of invalid logical block addresses as the to-be-erased logical block.

22. The storage management method according to claim 20, wherein the data categories are cold data and hot data that are determined according to data access frequency; and
the determining a to-be-erased logical block comprises: selecting a logical block whose data category is cold data as the to-be-erased logical block; and
adding a garbage collection forbidding indication into the erase instruction.

23. The storage management method according to any one of claim 20 to 22, before sending the erase instruction to the storage, further comprising: determining a to-be-migrated data page in the to-be-erased logical block according to a preset migration policy, and sending a data migration instruction to the storage, wherein the data migration instruction carries information about the to-be-migrated data page, and the data migration instruction is used to instruct storage to migrate the to-be-migrated data page in the storage.

24. The storage management method according to claim 23, wherein the determining a to-be-migrated data page in the to-be-erased logical block according to a preset migration policy comprises: determining a data page in the to-be-erased logical block as the to-be-migrated data page, wherein a current data category of the data page is hot data, and a logical block address of the data page is valid.

25. The storage management method according to any one of claims 16 to 24, wherein the storage comprises a preset correspondence between physical blocks and logical blocks, wherein each physical block is corresponding to one logical block, and each logical block is corresponding to at least one physical block;
the data write instruction further carries information about the at least one logical block; and
after the data write instruction is received, the writing, according to the data write instruction, the to-be-written data pages corresponding to the at least one logical block to a physical block corresponding to the at least one logical block specifically comprises: querying the correspondence between physical blocks and logical blocks according to the information that is about the at least one logical block and that is in the data write instruction, determining the physical block corresponding to the at least one logical block, and writing the to-be-written data pages corresponding to the at least one logical block to the physical block corresponding to the at least one logical block.

26. The storage management method according to any one of claims 16 to 24, wherein:
the data write instruction is sent by the manager after the manager writes the to-be-written data pages of different data categories into different caches and designates at least one logical block for data pages that are of a same data category and that are in each fully written cache, wherein the to-be-written data pages written to each cache are of a same data category; and
after the data write instruction is received, the writing, according to the data write instruction, the to-be-written data pages corresponding to the at least one logical block to a physical block corresponding to the at least one logical block comprises:
according to the data write instruction, allocating a physical block to the at least one logical block and writing the data pages corresponding to the at least one logical block to the allocated physical block, wherein a physical block allocated to each logical block of the at least one logical block is an idle physical block in the storage, and the idle physical block is marked as non-idle after being allocated; a total capacity of the physical block allocated to each logical block of the at least one logical block is greater than or equal to a capacity of each logical block in the at least one logical block.

27. The storage management method according to claim 26, further comprising:
recording a correspondence between physical blocks and logical blocks according to the information that is about the at least one logical block and that is in the data write instruction and information about the physical block allocated to the at least one logical block.

28. The storage management method according to claim 27, further comprising:
receiving an erase instruction sent by the manager, wherein the erase instruction is sent by the manager after the manager determines a to-be-erased logical block, and the erase instruction carries information about the to-be-erased logical block; and
determining a to-be-erased physical block according to the information that is about the to-be-erased logical block and that is in the erase instruction and the correspondence between physical blocks and logical blocks, and erasing the to-be-erased physical block.

29. The storage management method according to claim 28, further comprising:
receiving a data migration instruction sent by the manager, wherein the data migration instruction is sent by the manager after the manager determines a to-be-migrated data page in the to-be-erased logical block according to a preset migration policy, and the data migration instruction carries information about the to-be-migrated data page; and
migrating the to-be-migrated data page in the storage according to the data migration instruction.

## Patentansprüche

1. Speichersystem, umfassend:
einen Speicher; und
eine Speicherverwaltungsvorrichtung zum Verwalten des Speichers,
wobei die Speicherverwaltungsvorrichtung umfasst:
eine Klassifizierungsmodul (901), das zum Empfangen einer Datenschreibanforderung, die eine zu schreibende Datenseite umfasst, und Bestimmen einer Datenkategorie der zu schreibenden Datenseite konfiguriert ist;
ein Logikblockverwaltungsmodul (902), das zum Festlegen verschiedener logischer Blöcke für zu schreibende Datenseiten verschiedener Datenkategorien gemäß einem Klassifizierungsergebnis des Klassifizierungsmoduls konfiguriert ist; und
ein Schreibanweisungsmodul (903), das zum Senden einer Datenschreibanweisung gemäß den durch das Logikblockverwaltungsmodul für die zu schreibenden Datenseiten festgelegten logischen Blöcken an den Speicher konfiguriert ist, wobei die Datenschreibanweisung die zu schreibenden Datenseiten mitführt und für jede Datenseite einen für die jeweilige Datenseite festgelegten logischen Block anzeigt,
und die Datenschreibanweisung verwendet wird, um den Speicher zum Schreiben der zu schreibenden Datenseiten in mindestens einen physikalischen Block anzuweisen,
der dem mindestens einen logischen Block entspricht, wobei zu schreibende Datenseiten, die einem logischen Block entsprechen, in mindestens einen physikalischen Block geschrieben werden, und zu schreibende Datenseiten, die in jeden physikalischen Block geschrieben werden, nur einem logischen Block entsprechen; und
wobei der Speicher umfasst:
mehrere physikalische Blöcke;
ein Empfangsmodul (1102), das zum Empfangen einer Datenschreibanweisung konfiguriert ist, wobei die Datenschreibanweisung zu schreibende Datenseiten mitführt, die mindestens einem logischen Block entsprechen, und für jede Datenseite einen logischen Block anzeigt, der gemäß einer Datenkategorie der zu schreibenden Datenseiten für die jeweilige Datenseite festgelegt ist; und
ein Schreibmodul (1103), das zum Schreiben der zu schreibenden Datenseiten gemäß der Datenschreibanweisung in einen physikalischen Block konfiguriert ist, der dem mindestens einen logischen Block entspricht, wobei zu schreibende Datenseiten, die einem logischen Block entsprechen, in mindestens einen physikalischen Block geschrieben werden, und zu schreibende Datenseiten, die in jeden physikalischen Block geschrieben werden, nur einem logischen Block entsprechen.

2. Speichersystem nach Anspruch 1, wobei die Datenschreibanweisung ferner Informationen über den mindestens einen logischen Block mitführt; und
die Datenschreibanweisung insbesondere verwendet wird, um den Speicher anzuweisen zum: Abfragen einer Speicherentsprechung zwischen physikalischen Blöcken und logischen Blöcken, die im Speicher voreingestellt ist, gemäß den Informationen über den mindestens einen logischen Block, um einen physikalischen Block zu bestimmen, der dem mindestens einen logischen Block entspricht, und Schreiben der zu schreibenden Datenseiten, die dem mindestens einen logischen Block entsprechen, in den physikalischen Block, der dem mindestens einen logischen Block entspricht.

3. Speichersystem nach Anspruch 1, wobei die Speicherverwaltungsvorrichtung ferner umfasst:
ein Cache-Schreibmodul (1002), das zum Schreiben der zu schreibenden Datenseiten verschiedener Datenkategorien gemäß dem Klassifizierungsergebnis des Klassifizierungsmoduls in verschiedene Caches konfiguriert ist, wobei die zu schreibenden Datenseiten einer gleichen Datenkategorie in einen gleichen Cache geschrieben werden, und eine Kapazität jedes Caches kleiner als oder gleich wie eine Kapazität jedes logischen Blocks ist; wobei
das Logikblockverwaltungsmodul (1003) zum Festlegen eines logischen Blocks für Datenseiten konfiguriert ist, die von einer gleichen Kategorie und in jedem vollständig beschriebenen Cache sind; wobei die Datenschreibanweisung ferner Informationen über den mindestens einen logischen Block mitführt, und die Datenschreibanweisung ferner verwendet wird, um den Speicher vor dem Schreiben der zu schreibenden Datenseiten zum Zuweisen eines physikalischen Blocks zu dem mindestens einen logischen Block anzuweisen, und wobei ein physikalischer Block, der jedem logischen Block des mindestens einen logischen Blocks zugewiesen wird, ein unbelegter physikalischer Block im Speicher ist, und der unbelegte physikalische Block nach der Zuweisung als belegt markiert wird; wobei eine Gesamtkapazität des physikalischen Blocks, der jedem logischen Block des mindestens einen logischen Blocks zugewiesen ist, größer als oder gleich wie eine Kapazität jedes logischen Blocks in dem mindestens einen logischen Block ist.

4. Speichersystem nach Anspruch 2 oder 3, wobei das Logikblockverwaltungsmodul (1003) ferner so konfiguriert ist, dass es eine logische Blockadresse jeder zu schreibenden Datenseite in dem mindestens einen logischen Block aufzeichnet, die dem mindestens einen logischen Block entspricht, und eine Datenkategorie der Datenseiten aufzeichnet, die dem mindestens einen logischen Block entspricht.

5. Speichersystem nach Anspruch 4, wobei die Speicherverwaltungsvorrichtung ferner umfasst: ein Löschanweisungsmodul (1005), das zum Bestimmen eines zu löschenden logischen Blocks gemäß Datenseiten, die jedem logischen Block entsprechen, und Senden einer Löschanweisung an den Speicher konfiguriert ist, wobei die Löschanweisung Informationen über den zu löschenden logischen Block mitführt, und die Löschanweisung verwendet wird, um den Speicher zum Bestimmen eines zu löschenden physikalischen Blocks gemäß den Informationen, die über den zu löschenden logischen Block und in der Löschanweisung sind, und der Speicherentsprechung zwischen physikalischen Blöcken und logischen Blöcken, die im Speicher festgelegt ist, und Löschen des zu löschenden physikalischen Blocks anzuweisen.

6. Speichersystem nach Anspruch 5, wobei die Datenkategorien kalte Daten und heiße Daten sind, die gemäß der Datenzugriffshäufigkeit bestimmt werden; das Logikblockverwaltungsmodul (1003) ferner konfiguriert ist zum: Invalidieren einer logischen Blockadresse, die von der gespeicherten Datenseite und in einem logischen Block aufgezeichnet ist, welcher der gespeicherten Datenseite entspricht, wenn eine gespeicherte Datenseite aktualisiert werden muss; und,
dass ein Löschanweisungsmodul zum Bestimmen eines zu löschenden logischen Blocks konfiguriert ist, umfasst: Auswählen eines logischen Blocks, bei dessen Datenkategorie es sich um heiße Daten handelt, oder eines logischen Blocks, der eine große Menge von ungültigen logischen Blockadressen aufweist, als den zu löschenden logischen Block.

7. Speichersystem nach Anspruch 5, wobei die Datenkategorien kalte Daten und heiße Daten sind, die gemäß einer Datenzugriffshäufigkeit bestimmt werden; dass das Löschanweisungsmodul zum Bestimmen eines zu löschenden logischen Blocks konfiguriert ist, insbesondere umfasst: Auswählen eines logischen Blocks, bei dessen Datenkategorie es sich um kalte Daten handelt, als den zu löschenden logischen Block; und
das Löschanweisungsmodul (1005) ferner zum Einfügen einer Speicherbereinigungsverbotsanzeige in die Löschanweisung konfiguriert ist.

8. Speichersystem nach einem der Ansprüche 5 bis 7, wobei die Speicherverwaltungsvorrichtung ferner ein Migrationsanweisungsmodul (1006) umfasst; das Migrationsanweisungsmodul so konfiguriert ist, dass es eine zu migrierende Datenseite im zu löschenden logischen Block gemäß einer voreingestellten Migrationsrichtlinie bestimmt und eine Datenmigrationsanweisung an den Speicher sendet, bevor das Löschanweisungsmodul (1005) die Löschanweisung an den Speicher sendet, wobei die Datenmigrationsanweisung Informationen über die zu migrierende Datenseite mitführt, und die Datenmigrationsanweisung verwendet wird, um den Speicher zum Migrieren der zu migrierenden Datenseite im Speicher anzuweisen.

9. Speichersystem nach Anspruch 8, wobei, dass das Migrationsanweisungsmodul (1006) eine zu migrierende Datenseite im zu löschenden logischen Block gemäß einer voreingestellten Migrationsrichtlinie bestimmt, insbesondere umfasst:
Bestimmen einer Datenseite im zu löschenden logischen Block als die zu migrierende Datenseite, wobei es sich bei einer aktuellen Datenkategorie der Datenseite um heiße Daten handelt, und eine logische Blockadresse der Datenseite gültig ist.

10. Speichersystem nach einem der Ansprüche 1 bis 9, wobei der Speicher eine voreingestellte Entsprechung zwischen physikalischen Blöcken und logischen Blöcken umfasst, wobei jeder physikalische Block einem logischen Block entspricht, und jeder logische Block mindestens einem physikalischen Block entspricht;
die Datenschreibanweisung, die durch das Empfangsmodul empfangen wird, ferner Informationen über den mindestens einen logischen Block mitführt; und
das Schreibmodul nach Empfang der Datenschreibanweisung durch das Empfangsmodul (1102) insbesondere konfiguriert ist zum: Abfragen einer Entsprechung zwischen physikalischen Blöcken und logischen Blöcken, die durch das Konfigurationsmodul vorkonfiguriert ist, gemäß den Informationen, die über den mindestens einen logischen Block und in der Datenschreibanweisung sind, Bestimmen des physikalischen Blocks, der dem mindestens einen logischen Block entspricht, und Schreiben der zu schreibenden Datenseiten, die dem mindestens einen logischen Block entsprechen, in den physikalischen Block, der dem mindestens einen logischen Block entspricht.

11. Speichersystem nach einem der Ansprüche 1 bis 9, wobei:
die Datenschreibanweisung durch den Verwalter gesendet wird, nachdem der Verwalter die zu schreibenden Datenseiten verschiedener Datenkategorien in verschiedene Caches geschrieben und mindestens einen logischen Block für Datenseiten festgelegt hat, die von einer gleichen Datenkategorie und in jedem vollständig beschriebenen Cache sind, wobei die zu schreibenden Datenseiten, die in jeden Cache geschrieben werden, von einer gleichen Datenkategorie sind; und
das Schreibmodul nach Empfang der Datenschreibanweisung durch das Empfangsmodul (1102) insbesondere konfiguriert ist zum: Zuweisen eines physikalischen Blocks zu dem mindestens einen logischen Block gemäß der Datenschreibanweisung und Schreiben der Datenseiten, die dem mindestens einen logischen Block entsprechen, in den zugewiesenen physikalischen Block, wobei ein physikalischer Block, der jedem logischen Block des mindestens einen logischen Blocks zugewiesen wird, ein unbelegter physikalischer Block im Speicher ist, und
der unbelegte physikalische Block nach der Zuweisung als belegt markiert wird; wobei eine Gesamtkapazität des physikalischen Blocks, der jedem logischen Block des mindestens einen logischen Blocks zugewiesen ist, größer als oder gleich wie eine Kapazität jedes logischen Blocks in dem mindestens einen logischen Block ist.

12. Speichersystem nach Anspruch 11, wobei das Schreibmodul (1103) ferner zum Aufzeichnen einer Entsprechung zwischen physikalischen Blöcken und logischen Blöcken gemäß den Informationen, die über den mindestens einen logischen Block und in der Datenschreibanweisung sind, und Informationen über den physikalischen Block, der dem mindestens einen logischen Block zugewiesen ist, konfiguriert ist.

13. Speichersystem nach Anspruch 12, wobei das Empfangsmodul (1102) ferner zum Empfangen einer Löschanweisung konfiguriert ist, die vom Verwalter gesendet wird, wobei die Löschanweisung vom Verwalter gesendet wird, nachdem der Verwalter einen zu löschenden logischen Block bestimmt hat, und die Löschanweisung Informationen über den zu löschenden logischen Block mitführt; und
der Speicher ferner umfasst: ein Löschmodul (1104), das zum Bestimmen eines zu löschenden physikalischen Blocks gemäß den Informationen, die über den zu löschenden logischen Block und in der Löschanweisung sind, und der Entsprechung zwischen physikalischen Blöcken und logischen Blöcken und Löschen des zu löschenden physikalischen Blocks konfiguriert ist.

14. Speichersystem nach Anspruch 13, wobei das Empfangsmodul (1102) ferner zum Empfangen einer Datenmigrationsanweisung konfiguriert ist, die vom Verwalter gesendet wird, wobei die Datenmigrationsanweisung vom Verwalter gesendet wird, nachdem der Verwalter eine zu migrierende Datenseite im zu löschenden logischen Block gemäß einer voreingestellten Migrationsrichtlinie bestimmt hat, und die Datenmigrationsanweisung Informationen über die zu migrierende Datenseite mitführt, und
der Speicher ferner ein Migrationsmodul (1105) umfasst, das zum Migrieren der zu migrierenden Datenseite im Speicher gemäß der Datenmigrationsanweisung konfiguriert ist.

15. Hybridspeichervorrichtung, umfassend ein Festplattenlaufwerk und das Speichersystem nach einem der Ansprüche 1 bis 14, wobei der Speicher als Cache des Magnetplattenspeichers verwendet wird.

16. Speicherverwaltungsverfahren, das auf ein Speichersystem angewendet wird, das einen Speicher und eine Speicherverwaltungsvorrichtung zum Verwalten des Speichers umfasst, wobei der Speicher mehrere physikalische Blöcke umfasst, und das Verfahren umfasst:
Empfangen (S1301) einer Datenschreibanweisung, die eine zu schreibende Datenseite umfasst, und Bestimmen einer Datenkategorie der zu schreibenden Datenseite, durch die Speicherverwaltungsvorrichtung;
Festlegen (S1302) eines logischen Blocks für die zu schreibende Datenseite durch die Speicherverwaltungsvorrichtung, wobei der festgelegte logische Block zu schreibenden Datenseiten einer gleichen Datenkategorie entspricht;
Senden (S1303) einer Datenschreibanweisung durch die Speicherverwaltungsvorrichtung an den Speicher, wobei die Datenschreibanweisung die zu schreibenden Datenseiten mitführt und für jede Datenseite einen für die jeweilige Datenseite festgelegten logischen Block anzeigt, und die Datenschreibanweisung verwendet wird, um den Speicher gemäß der Datenschreibanweisung zum Schreiben der zu schreibenden Datenseiten in mindestens einen physikalischen Block anzuweisen, der dem mindestens einen logischen Block entspricht, wobei zu schreibende Datenseiten, die einem logischen Block entsprechen, in mindestens einen physikalischen Block geschrieben werden, und zu schreibende Datenseiten, die in jeden physikalischen Block geschrieben werden, nur einem logischen Block entsprechen; und
Empfangen der Datenschreibanweisung durch den Speicher von der Speicherverwaltungsvorrichtung, wobei die Datenschreibanweisung zu schreibende Datenseiten mitführt und für jede Datenseite einen logischen Block anzeigt, der für die jeweilige Datenseite festgelegt ist, wobei jeder logische Block zu schreibenden Datenseiten einer gleichen Datenkategorie entspricht; und
Schreiben der zu schreibenden Datenseiten durch den Speicher gemäß der Datenschreibanweisung in mindestens einen physikalischen Block, der dem mindestens einen logischen Block entspricht, wobei zu schreibende Datenseiten, die einem logischen Block entsprechen, in mindestens einen physikalischen Block geschrieben werden, und zu schreibende Datenseiten, die in jeden physikalischen Block geschrieben werden, nur einem logischen Block entsprechen.

17. Speicherverwaltungsverfahren nach Anspruch 16, wobei die Datenschreibanweisung ferner Informationen über den mindestens einen logischen Block mitführt; und
die Datenschreibanweisung den Speicher ferner anweist zum: Abfragen einer Entsprechung zwischen physikalischen Blöcken und logischen Blöcken, die im Speicher voreingestellt ist, gemäß den Informationen, die über den mindestens einen logischen Block und in der Datenschreibanweisung sind, um einen physikalischen Block zu bestimmen, der dem mindestens einen logischen Block entspricht, und Schreiben der zu schreibenden Datenseiten, die dem mindestens einen logischen Block entsprechen, in den physikalischen Block, der dem mindestens einen logischen Block entspricht.

18. Speicherverwaltungsverfahren nach Anspruch 16, ferner umfassend: Schreiben (S1502) der zu schreibenden Datenseiten verschiedener Datenkategorien in verschiedene Caches, wobei die zu schreibenden Datenseiten einer gleichen Datenkategorie in einen gleichen Cache geschrieben werden, und eine Kapazität jedes Caches kleiner als oder gleich wie eine Kapazität jedes logischen Blocks ist; wobei ein logischer Block für die zu schreibenden Datenseiten festgelegt wird, die vollständig in einen Cache geschrieben werden; wobei die Datenschreibanweisung ferner Informationen über den mindestens einen logischen Block mitführt, und die Datenschreibanweisung ferner verwendet wird, um den Speicher zum Zuweisen eines physikalischen Blocks zu dem mindestens einen logischen Block vor dem Schreiben der zu schreibenden Datenseiten anzuweisen, und
wobei ein physikalischer Block, der jedem logischen Block des mindestens einen logischen Blocks zugewiesen wird, ein unbelegter physikalischer Block im Speicher ist, und der unbelegte physikalische Block nach der Zuweisung als belegt markiert wird; wobei eine Gesamtkapazität des physikalischen Blocks, der jedem logischen Block des mindestens einen logischen Blocks zugewiesen ist, größer als oder gleich wie eine Kapazität jedes logischen Blocks in dem mindestens einen logischen Block ist.

19. Speicherverwaltungsverfahren nach Anspruch 17 oder 18, ferner umfassend nach dem Festlegen verschiedener logischer Blöcke für zu schreibende Datenseiten verschiedener Datenkategorien: Aufzeichnen einer logischen Blockadresse jeder zu schreibenden Datenseite, die dem mindestens einen logischen Block entspricht, in dem mindestens einen logischen Block.

20. Speicherverwaltungsverfahren nach Anspruch 19, ferner umfassend: Bestimmen eines zu löschenden logischen Blocks gemäß Datenseiten, die jedem logischen Block entsprechen, und Senden einer Löschanweisung an den Speicher, wobei die Löschanweisung Informationen über den zu löschenden logischen Block mitführt, und die Löschanweisung verwendet wird, um den Speicher zum Bestimmen eines zu löschenden physikalischen Blocks gemäß den Informationen, die über den zu löschenden logischen Block und in der Löschanweisung sind, und der Speicherentsprechung zwischen physikalischen Blöcken und logischen Blöcken, die im Speicher festgelegt ist, und Löschen des zu löschenden physikalischen Blocks anzuweisen.

21. Speicherverwaltungsverfahren nach Anspruch 20, wobei die Datenkategorien kalte Daten und heiße Daten sind, die gemäß der Datenzugriffshäufigkeit bestimmt werden; und das Verfahren ferner umfasst: Invalidieren einer logischen Adresse, die von der gespeicherten Datenseite und in einem logischen Block aufgezeichnet ist, welcher der gespeicherten Datenseite entspricht, wenn eine gespeicherte Datenseite aktualisiert werden muss; und
das Bestimmen eines zu löschenden logischen Blocks umfasst: Auswählen eines logischen Blocks, bei dessen Datenkategorie es sich um heiße Daten handelt, oder eines logischen Blocks, der eine große Menge von ungültigen logischen Blockadressen aufweist, als den zu löschenden logischen Block.

22. Speicherverwaltungsverfahren nach Anspruch 20, wobei die Datenkategorien kalte Daten und heiße Daten sind, die gemäß einer Datenzugriffshäufigkeit bestimmt werden; und
das Bestimmen eines zu löschenden logischen Blocks umfasst: Auswählen eines logischen Blocks, bei dessen Datenkategorie es sich um kalte Daten handelt, als den zu löschenden logischen Block; und
Einfügen einer Speicherbereinigungsverbotsanzeige in die Löschanweisung.

23. Speicherverwaltungsverfahren nach einem der Ansprüche 20 bis 22, ferner umfassend vor dem Senden der Löschanweisung an den Speicher: Bestimmen einer zu migrierenden Datenseite im zu löschenden logischen Block gemäß einer voreingestellten Migrationsrichtlinie und Senden einer Datenmigrationsanweisung an den Speicher, wobei die Datenmigrationsanweisung Informationen über die zu migrierende Datenseite mitführt, und die Datenmigrationsanweisung verwendet wird, um den Speicher zum Migrieren der zu migrierenden Datenseite im Speicher anzuweisen.

24. Speicherverwaltungsverfahren nach Anspruch 23, wobei das Bestimmen einer zu migrierenden Datenseite im zu löschenden logischen Block gemäß einer voreingestellten Migrationsrichtlinie umfasst: Bestimmen einer Datenseite im zu löschenden logischen Block als die zu migrierende Datenseite, wobei es sich bei einer aktuellen Datenkategorie der Datenseite um heiße Daten handelt, und eine logische Blockadresse der Datenseite gültig ist.

25. Speicherverwaltungsverfahren nach einem der Ansprüche 16 bis 24, wobei der Speicher eine voreingestellte Entsprechung zwischen physikalischen Blöcken und logischen Blöcken umfasst, wobei jeder physikalische Block einem logischen Block entspricht, und jeder logische Block mindestens einem physikalischen Block entspricht;
die Datenschreibanweisung ferner Informationen über den mindestens einen logischen Block mitführt, und
das Schreiben der zu schreibenden Datenseiten, die dem mindestens einen logischen Block entsprechen, nach Empfang der Datenschreibanweisung gemäß der Datenschreibanweisung in einen physikalischen Block, der dem mindestens einen logischen Block entspricht, insbesondere umfasst: Abfragen der Entsprechung zwischen physikalischen Blöcken und logischen Blöcken gemäß den Informationen, die über den mindestens einen logischen Block und in der Datenschreibanweisung sind, Bestimmen des physikalischen Blocks, der dem mindestens einen logischen Block entspricht, und Schreiben der zu schreibenden Datenseiten, die dem mindestens einen logischen Block entsprechen, in den physikalischen Block, der dem mindestens einen logischen Block entspricht.

26. Speicherverwaltungsverfahren nach einem der Ansprüche 16 bis 24, wobei:
die Datenschreibanweisung durch den Verwalter gesendet wird, nachdem der Verwalter die zu schreibenden Datenseiten verschiedener Datenkategorien in verschiedene Caches geschrieben und mindestens einen logischen Block für Datenseiten festgelegt hat, die von einer gleichen Datenkategorie und in jedem vollständig beschriebenen Cache sind, wobei die zu schreibenden Datenseiten, die in jeden Cache geschrieben werden, von einer gleichen Datenkategorie sind; und
das Schreiben der zu schreibenden Datenseiten, die dem mindestens einen logischen Block entsprechen, nach Empfang der Datenschreibanweisung gemäß der Datenschreibanweisung in einen physikalischen Block, der dem mindestens einen logischen Block entspricht, umfasst: Zuweisen eines physikalischen Blocks zu dem mindestens einen logischen Block gemäß der Datenschreibanweisung und Schreiben der Datenseiten, die dem mindestens einen logischen Block entsprechen, in den zugewiesenen physikalischen Block, wobei ein physikalischer Block, der jedem logischen Block des mindestens einen logischen Blocks zugewiesen wird, ein unbelegter physikalischer Block im Speicher ist, und der unbelegte physikalische Block nach der Zuweisung als belegt markiert wird; wobei eine Gesamtkapazität des physikalischen Blocks, der jedem logischen Block des mindestens einen logischen Blocks zugewiesen ist, größer als oder gleich wie eine Kapazität jedes logischen Blocks in dem mindestens einen logischen Block ist.

27. Speicherverwaltungsverfahren nach Anspruch 26, ferner umfassend: Aufzeichnen einer Entsprechung zwischen physikalischen Blöcken und logischen Blöcken gemäß den Informationen, die über den mindestens einen logischen Block und in der Datenschreibanweisung sind, und Informationen über den physikalischen Block, der dem mindestens einen logischen Block zugewiesen ist.

28. Speicherverwaltungsverfahren nach Anspruch 27, ferner umfassend: Empfangen einer Löschanweisung, die vom Verwalter gesendet wird, wobei die Löschanweisung vom Verwalter gesendet wird, nachdem der Verwalter einen zu löschenden logischen Block bestimmt hat, und die Löschanweisung Informationen über den zu löschenden logischen Block mitführt, und
Bestimmen eines zu löschenden physikalischen Blocks gemäß den Informationen, die über den zu löschenden logischen Block und in der Löschanweisung sind, und der Entsprechung zwischen physikalischen Blöcken und logischen Blöcken und Löschen des zu löschenden physikalischen Blocks.

29. Speicherverwaltungsverfahren nach Anspruch 28, ferner umfassend: Empfangen einer Datenmigrationsanweisung, die vom Verwalter gesendet wird, wobei die Datenmigrationsanweisung vom Verwalter gesendet wird, nachdem der Verwalter eine zu migrierende Datenseite im zu löschenden logischen Block gemäß einer voreingestellten Migrationsrichtlinie bestimmt hat, und die Datenmigrationsanweisung Informationen über die zu migrierende Datenseite mitführt, und
Migrieren der zu migrierenden Datenseite im Speicher gemäß der Datenmigrationsanweisung.

## Revendications

1. Système de stockage comprenant :
une mémoire ; et
un appareil de gestion de mémoire pour gérer la mémoire,
dans lequel l'appareil de gestion de mémoire comprend :
un module de classification (901), configuré pour recevoir une demande d'écriture de données comprenant une page de données à écrire et déterminer une catégorie de données de la page de données à écrire ;
un module de gestion de blocs logiques (902), configuré pour désigner différents blocs logiques pour des pages de données à écrire de différentes catégories de données selon un résultat de classification du module de classification ; et
un module d'instruction d'écriture (903), configuré pour envoyer une instruction d'écriture de données à la mémoire selon les blocs logiques désignés par le module de gestion de blocs logiques pour les pages de données à écrire, dans lequel l'instruction d'écriture de données transporte les pages de données à écrire et indique, pour chaque page de données, un bloc logique désigné pour la page de données respective, et l'instruction d'écriture de données est utilisée pour ordonner à la mémoire d'écrire les pages de données à écrire dans au moins un bloc physique correspondant à l'au moins un bloc logique, dans lequel les pages de données à écrire correspondant à un bloc logique sont écrites dans au moins un bloc physique, et les pages de données à écrire écrites dans chaque bloc physique correspondent à un seul bloc logique ; et
dans lequel la mémoire comprend :
de multiples blocs physiques ;
un module de réception (1102), configuré pour recevoir une instruction d'écriture de données, dans lequel l'instruction d'écriture de données transporte des pages de données à écrire correspondant à au moins un bloc logique et indique, pour chaque page de données, un bloc logique désigné pour la page de données respective selon une catégorie de données des pages de données à écrire ; et
un module d'écriture (1103), configuré pour écrire, selon l'instruction d'écriture de données, les pages de données à écrire dans un bloc physique correspondant à l'au moins un bloc logique, dans lequel les pages de données à écrire correspondant à un bloc logique sont écrites dans au moins un bloc physique, et les pages de données à écrire écrites dans chaque bloc physique correspondent à un seul bloc logique.

2. Système de stockage selon la revendication 1, dans lequel l'instruction d'écriture de données transporte en outre des informations sur l'au moins un bloc logique ; et l'instruction d'écriture de données est spécifiquement utilisée pour ordonner à la mémoire de : interroger, en fonction des informations relatives à l'au moins un bloc logique, un stockage de correspondance entre blocs physiques et blocs logiques qui est prédéfini dans la mémoire pour déterminer un bloc physique correspondant à l'au moins un bloc logique, et écrire les pages de données à écrire correspondant à l'au moins un bloc logique dans le bloc physique correspondant à l'au moins un bloc logique.

3. Système de stockage selon la revendication 1, dans lequel l'appareil de gestion de mémoire comprend en outre :
un module d'écriture de cache (1002), configuré pour écrire les pages de données à écrire de différentes catégories de données dans différents caches selon le résultat de classification du module de classification, dans lequel les pages de données à écrire d'une même catégorie de données sont écrites dans un même cache, et une capacité de chaque cache est inférieure ou égale à une capacité de chaque bloc logique ; dans lequel le module de gestion de blocs logiques (1003) est configuré pour désigner un bloc logique pour des pages de données qui sont d'une même catégorie de données et qui sont dans chaque cache entièrement écrites ; dans lequel l'instruction d'écriture de données transporte en outre des informations sur l'au moins un bloc logique, et
l'instruction d'écriture de données est en outre utilisée pour ordonner à la mémoire d'allouer un bloc physique à l'au moins un bloc logique avant d'écrire les pages de données à écrire, et dans lequel un bloc physique alloué à chaque bloc logique de l'au moins un bloc logique est un bloc physique libre dans la mémoire, et le bloc physique libre est marqué comme non libre après avoir été alloué ; une capacité totale du bloc physique alloué à chaque bloc logique de l'au moins un bloc logique est supérieure ou égale à une capacité de chaque bloc logique dans l'au moins un bloc logique.

4. Système de stockage selon la revendication 2 ou 3, dans lequel le module de gestion de blocs logiques (1003) est en outre configuré pour enregistrer, dans l'au moins un bloc logique, une adresse de bloc logique de chaque page de données à écrire correspondant à l'au moins un bloc logique, et enregistrer une catégorie de données des pages de données correspondant à l'au moins un bloc logique.

5. Système de stockage selon la revendication 4, dans lequel le dispositif de gestion de mémoire comprend en outre : un module d'instruction d'effacement (1005), configuré pour déterminer un bloc logique à effacer selon des pages de données correspondant à chaque bloc logique, et envoyer une instruction d'effacement à la mémoire, dans lequel l'instruction d'effacement transporte des informations sur le bloc logique à effacer, et l'instruction d'effacement est utilisée pour ordonner à la mémoire de déterminer un bloc physique à effacer selon les informations qui concernent le bloc logique à effacer et qui sont dans l'instruction d'effacement et la correspondance de stockage entre blocs physiques et blocs logiques qui est établie dans la mémoire, et d'effacer le bloc physique à effacer.

6. Système de stockage selon la revendication 5, dans lequel les catégories de données sont des données froides et des données chaudes qui sont déterminées selon la fréquence d'accès aux données ; le module de gestion de blocs logiques (1003) est en outre configuré pour : lorsqu'une page de données stockée doit être mise à jour, invalider une adresse de bloc logique qui est de la page de données stockée et qui est enregistrée dans un bloc logique correspondant à la page de données stockée ; et
le fait qu'un module d'instruction d'effacement soit configuré pour déterminer un bloc logique à effacer comprend l'étape consistant à : sélectionner, comme bloc logique à effacer, un bloc logique dont la catégorie de données est constituée de données chaudes ou un bloc logique qui présente une grande quantité d'adresses de blocs logiques invalides.

7. Système de stockage selon la revendication 5, dans lequel les catégories de données sont des données froides et des données chaudes qui sont déterminées selon la fréquence d'accès aux données ; le fait que le module d'instruction d'effacement soit configuré pour déterminer un bloc logique à effacer comprend spécifiquement l'étape consistant à : sélectionner, comme bloc logique à effacer, un bloc logique dont la catégorie de données est constituée de données froides ; et
le module d'instruction d'effacement (1005) est en outre configuré pour ajouter une indication d'interdiction de récupération de l'espace mémoire dans l'instruction d'effacement.

8. Système de stockage selon l'une quelconque des revendications 5 à 7, dans lequel l'appareil de gestion de mémoire comprend en outre un module d'instruction de migration (1006); avant que le module d'instruction d'effacement (1005) envoie l'instruction d'effacement à la mémoire, le module d'instruction de migration est configuré pour déterminer une page de données à faire migrer dans le bloc logique à effacer selon une politique de migration prédéfinie, et envoyer une instruction de migration de données à la mémoire, dans lequel l'instruction de migration de données transporte des informations sur la page de données à faire migrer, et l'instruction de migration de données est utilisée pour ordonner à la mémoire de faire migrer la page de données à faire migrer dans la mémoire.

9. Système de stockage selon la revendication 8, dans lequel la détermination par le module d'instruction de migration (1006) d'une page de données à faire migrer dans le bloc logique à effacer selon une politique de migration prédéfinie consiste spécifiquement à : déterminer une page de données dans le bloc logique à effacer en tant que page de données à faire migrer, dans lequel une catégorie de données actuelle de la page de données est des données chaudes, et une adresse de bloc logique de la page de données est valide.

10. Système de stockage selon l'une quelconque des revendications 1 à 9, dans lequel la mémoire comprend une correspondance prédéfinie entre blocs physiques et blocs logiques, dans lequel chaque bloc physique correspond à un bloc logique, et chaque bloc logique correspond à au moins un bloc physique ;
l'instruction d'écriture de données reçue par le module de réception transporte en outre des informations sur l'au moins un bloc logique ; et
après que le module de réception (1102) a reçu l'instruction d'écriture de données, le module d'écriture est spécifiquement configuré pour : interroger, en fonction des informations qui concernent l'au moins un bloc logique et qui se trouvent dans l'instruction d'écriture de données, une correspondance entre blocs physiques et blocs logiques qui est préconfigurée par le module de configuration, déterminer le bloc physique correspondant à l'au moins un bloc logique, et écrire les pages de données à écrire correspondant à l'au moins un bloc logique dans le bloc physique correspondant à l'au moins un bloc logique.

11. Système de stockage selon l'une quelconque des revendications 1 à 9, dans lequel :
l'instruction d'écriture de données est envoyée par le gestionnaire après que le gestionnaire a écrit les pages de données à écrire de différentes catégories de données dans différents caches et a désigné au moins un bloc logique pour des pages de données qui sont d'une même catégorie de données et qui sont dans chaque cache entièrement écrites, dans lequel les pages de données à écrire écrites dans chaque cache sont d'une même catégorie de données ; et
après que le module de réception (1102) a reçu l'instruction d'écriture de données, le module d'écriture est spécifiquement configuré pour : selon l'instruction d'écriture de données, allouer un bloc physique à l'au moins un bloc logique et écrire les pages de données correspondant à l'au moins un bloc logique dans le bloc physique alloué, dans lequel un bloc physique alloué à chaque bloc logique de l'au moins un bloc logique est un bloc physique libre dans la mémoire, et le bloc physique libre est marqué comme non libre après avoir été alloué ; une capacité totale du bloc physique alloué à chaque bloc logique de l'au moins un bloc logique est supérieure ou égale à une capacité de chaque bloc logique dans l'au moins un bloc logique.

12. Système de stockage selon la revendication 11, dans lequel le module d'écriture (1103) est en outre configuré pour enregistrer une correspondance entre blocs physiques et blocs logiques selon les informations qui concernent l'au moins un bloc logique et qui sont dans l'instruction d'écriture de données et les informations concernant le bloc physique alloué à l'au moins un bloc logique.

13. Système de stockage selon la revendication 12, dans lequel le module de réception (1102) est en outre configuré pour recevoir une instruction d'effacement envoyée par le gestionnaire, dans lequel l'instruction d'effacement est envoyée par le gestionnaire après que le gestionnaire détermine un bloc logique à effacer, et l'instruction d'effacement transporte des informations sur le bloc logique à effacer ; et
la mémoire comprend en outre : un module d'effacement (1104), configuré pour déterminer un bloc physique à effacer selon les informations qui concernent le bloc logique à effacer et qui sont dans l'instruction d'effacement et la correspondance entre blocs physiques et blocs logiques, et effacer le bloc physique à effacer.

14. Système de stockage selon la revendication 13, dans lequel le module de réception (1102) est en outre configuré pour recevoir une instruction de migration de données envoyée par le gestionnaire, dans lequel l'instruction de migration de données est envoyée par le gestionnaire après que le gestionnaire détermine une page de données à faire migrer dans le bloc logique à effacer selon une politique de migration prédéfinie, et l'instruction de migration de données transporte des informations sur la page de données à faire migrer ; et
la mémoire comprend en outre un module de migration (1105), configuré pour faire migrer la page de données à faire migrer dans la mémoire selon l'instruction de migration de données.

15. Appareil de mémoire hybride, comprenant un disque dur et le système de stockage selon l'une quelconque des revendications 1 à 14, dans lequel la mémoire est utilisée en tant que cache de la mémoire à disques magnétiques.

16. Procédé de gestion de mémoire, appliqué à un système de stockage qui comprend une mémoire et un appareil de gestion de mémoire pour gérer la mémoire, dans lequel la mémoire comprend de multiples blocs physiques, et le procédé comprend les étapes consistant à :
recevoir (S1301), par l'appareil de gestion de mémoire, une demande d'écriture de données comprenant une page de données à écrire et déterminer une catégorie de données de la page de données à écrire ;
désigner (S1302), par l'appareil de gestion de mémoire, un bloc logique pour la page de données à écrire, dans lequel le bloc logique désigné correspond à des pages de données à écrire d'une même catégorie de données ;
envoyer (S1303), par l'appareil de gestion de mémoire, une instruction d'écriture de données à la mémoire, dans lequel l'instruction d'écriture de données transporte les pages de données à écrire et indique, pour chaque page de données, un bloc logique désigné pour la page de données respective, et l'instruction d'écriture de données est utilisée pour ordonner à la mémoire d'écrire, selon l'instruction d'écriture de données,
les pages de données à écrire dans au moins un bloc physique correspondant à l'au moins un bloc logique, dans lequel les pages de données à écrire correspondant à un bloc logique sont écrites dans au moins un bloc physique, et des pages de données à écrire écrites dans chaque bloc physique ne correspondent qu'à un seul bloc logique ;
recevoir, par la mémoire, l'instruction d'écriture de données à partir de l'appareil de gestion de mémoire, dans lequel l'instruction d'écriture de données transporte des pages de données à écrire et indique, pour chaque page de données, un bloc logique désigné pour la page de données respective, dans lequel chaque bloc logique correspond à des pages de données à écrire d'une même catégorie de données ; et
écrire, par la mémoire, selon l'instruction d'écriture de données, les pages de données à écrire dans au moins un bloc physique correspondant à l'au moins un bloc logique,
dans lequel les pages de données à écrire correspondant à un bloc logique sont écrites dans au moins un bloc physique, et des pages de données à écrire écrites dans chaque bloc physique ne correspondent qu'à un seul bloc logique.

17. Procédé de gestion de mémoire selon la revendication 16, dans lequel l'instruction d'écriture de données transporte en outre des informations sur l'au moins un bloc logique ; et
l'instruction d'écriture de données ordonne en outre à la mémoire de : interroger, selon les informations qui concernent l'au moins un bloc logique et qui se trouvent dans l'instruction d'écriture de données, une correspondance entre blocs physiques et blocs logiques qui est prédéfinie dans la mémoire pour déterminer un bloc physique correspondant à l'au moins un bloc logique, et écrire les pages de données à écrire correspondant à l'au moins un bloc logique dans le bloc physique correspondant à l'au moins un bloc logique.

18. Procédé de gestion de mémoire selon la revendication 16, consistant en outre à :
écrire (S 1502) les pages de données à écrire de différentes catégories de données dans différents caches, dans lequel les pages de données à écrire d'une même catégorie de données sont écrites dans un même cache, et une capacité de chaque cache est inférieure ou égale à une capacité de chaque bloc logique ;
dans lequel un bloc logique est désigné pour les pages de données à écrire qui sont entièrement écrites dans un cache ; dans lequel l'instruction d'écriture de données transporte en outre des informations sur l'au moins un bloc logique, et l'instruction d'écriture de données est en outre utilisée pour demander à la mémoire d'allouer un bloc physique à l'au moins un bloc logique avant d'écrire les pages de données à écrire, et
dans lequel un bloc physique alloué à chaque bloc logique de l'au moins un bloc logique est un bloc physique libre dans la mémoire, et le bloc physique libre est marqué comme non libre après avoir été alloué ; une capacité totale du bloc physique alloué à chaque bloc logique de l'au moins un bloc logique est supérieure ou égale à une capacité de chaque bloc logique dans l'au moins un bloc logique.

19. Procédé de gestion de mémoire selon la revendication 17 ou 18, après la désignation de différents blocs logiques pour des pages de données à écrire de différentes catégories de données, consistant en outre à : enregistrer, dans l'au moins un bloc logique, une adresse de bloc logique de chaque page de données à écrire correspondant à l'au moins un bloc logique.

20. Procédé de gestion de mémoire selon la revendication 19, consistant en outre à :
déterminer un bloc logique à effacer selon des pages de données correspondant à chaque bloc logique, et envoyer une instruction d'effacement à la mémoire, dans lequel l'instruction d'effacement transporte des informations sur le bloc logique à effacer, et
l'instruction d'effacement est utilisée pour ordonner à la mémoire de déterminer un bloc physique à effacer selon les informations qui concernent le bloc logique à effacer et qui sont dans l'instruction d'effacement et la correspondance de stockage entre blocs physiques et blocs logiques qui est définie dans la mémoire, et d'effacer le bloc physique à effacer.

21. Procédé de gestion de mémoire selon la revendication 20, dans lequel les catégories de données sont des données froides et des données chaudes qui sont déterminées selon la fréquence d'accès aux données ; le procédé consiste en outre à : lorsqu'une page de données stockée doit être mise à jour, invalider une adresse logique qui est de la page de données stockée et qui est enregistrée dans un bloc logique correspondant à la page de données stockée ; et
la détermination d'un bloc logique à effacer consiste à : sélectionner un bloc logique dont la catégorie de données est constituée de données chaudes ou un bloc logique qui a une grande quantité d'adresses de blocs logiques invalides comme bloc logique à effacer.

22. Procédé de gestion de mémoire selon la revendication 20, dans lequel les catégories de données sont des données froides et des données chaudes qui sont déterminées selon la fréquence d'accès aux données ; et
la détermination d'un bloc logique à effacer consiste à : sélectionner un bloc logique dont la catégorie de données est constituée de données froides comme bloc logique à effacer ; et
ajouter une indication interdisant la récupération de l'espace mémoire dans l'instruction d'effacement.

23. Procédé de gestion de mémoire selon l'une quelconque des revendications 20 à 22, consistant en outre, avant d'envoyer l'instruction d'effacement à la mémoire : à déterminer une page de données à faire migrer dans le bloc logique à effacer selon une politique de migration prédéfinie, et à envoyer une instruction de migration de données à la mémoire, dans lequel l'instruction de migration de données transporte des informations sur la page de données à faire migrer, et l'instruction de migration de données est utilisée pour ordonner à la mémoire de faire migrer la page de données à faire migrer dans la mémoire.

24. Procédé de gestion de mémoire selon la revendication 23, dans lequel la détermination d'une page de données à faire migrer dans le bloc logique à effacer selon une politique de migration prédéfinie consiste à : déterminer une page de données dans le bloc logique à effacer en tant que page de données à faire migrer, dans lequel une catégorie de données actuelle de la page de données est constituée de données chaudes, et une adresse de bloc logique de la page de données est valide.

25. Procédé de gestion de mémoire selon l'une quelconque des revendications 16 à 24, dans lequel la mémoire comprend une correspondance prédéfinie entre blocs physiques et blocs logiques, dans lequel chaque bloc physique correspond à un bloc logique, et chaque bloc logique correspond à au moins un bloc physique ;
l'instruction d'écriture de données transporte en outre des informations sur l'au moins un bloc logique ; et
après la réception de l'instruction d'écriture de données, l'écriture, selon l'instruction d'écriture de données, des pages de données à écrire correspondant à l'au moins un bloc logique dans un bloc physique correspondant à l'au moins un bloc logique consiste spécifiquement à : interroger la correspondance entre blocs physiques et blocs logiques selon les informations qui concernent l'au moins un bloc logique et qui sont dans l'instruction d'écriture de données, déterminer le bloc physique correspondant à l'au moins un bloc logique, et écrire les pages de données à écrire correspondant à l'au moins un bloc logique dans le bloc physique correspondant à l'au moins un bloc logique.

26. Procédé de gestion de mémoire selon l'une quelconque des revendications 16 à 24, dans lequel :
l'instruction d'écriture de données est envoyée par le gestionnaire après que le gestionnaire a écrit les pages de données à écrire de différentes catégories de données dans différents caches et a désigné au moins un bloc logique pour des pages de données qui sont d'une même catégorie de données et qui sont dans chaque cache entièrement écrites, dans lequel les pages de données à écrire écrites dans chaque cache sont d'une même catégorie de données ; et
après la réception de l'instruction d'écriture de données, l'écriture, selon l'instruction d'écriture de données, des pages de données à écrire correspondant à l'au moins un bloc logique dans un bloc physique correspondant à l'au moins un bloc logique consiste à : selon l'instruction d'écriture de données, allouer un bloc physique à l'au moins un bloc logique et écrire les pages de données correspondant à l'au moins un bloc logique dans le bloc physique alloué, dans lequel un bloc physique alloué à chaque bloc logique de l'au moins un bloc logique est un bloc physique libre dans la mémoire, et le bloc physique libre est marqué comme non libre après avoir été alloué ; une capacité totale du bloc physique alloué à chaque bloc logique de l'au moins un bloc logique est supérieure ou égale à une capacité de chaque bloc logique dans l'au moins un bloc logique.

27. Procédé de gestion de mémoire selon la revendication 26, consistant en outre à :
enregistrer une correspondance entre blocs physiques et blocs logiques selon les informations qui concernent l'au moins un bloc logique et qui se trouvent dans l'instruction d'écriture de données et des informations concernant le bloc physique alloué à l'au moins un bloc logique.

28. Procédé de gestion de mémoire selon la revendication 27, consistant en outre à :
recevoir une instruction d'effacement envoyée par le gestionnaire, dans lequel l'instruction d'effacement est envoyée par le gestionnaire après que le gestionnaire a déterminé un bloc logique à effacer, et l'instruction d'effacement transporte des informations sur le bloc logique à effacer ; et
déterminer un bloc physique à effacer selon les informations qui concernent le bloc logique à effacer et qui se trouvent dans l'instruction d'effacement et la correspondance entre blocs physiques et blocs logiques, et effacer le bloc physique à effacer.

29. Procédé de gestion de mémoire selon la revendication 28, consistant en outre à :
recevoir une instruction de migration de données envoyée par le gestionnaire, dans lequel l'instruction de migration de données est envoyée par le gestionnaire après que le gestionnaire détermine une page de données à faire migrer dans le bloc logique à effacer selon une politique de migration prédéfinie, et l'instruction de migration de données transporte des informations sur la page de données à faire migrer ; et
faire migrer la page de données à faire migrer dans la mémoire selon l'instruction de migration de données.
